# EUROPEAN PATENT APPLICATION

(11) **EP 4 742 694 A1**
(43) Date of publication of application: **13.05.2026**
(21) Application number: 25212484.7
(22) Date of filing: 30.10.2025
(51) Int. Cl.: H04N 25/46, H04N 25/59, H04N 25/778

(54) **IMAGE SENSOR AND OPERATION METHOD THEREOF**

(30) Priority: 06.11.2024 KR 20240156329; 01.08.2025 US 202519287936
(71) Applicant: Samsung Electronics Co., Ltd., Suwon-si, Gyeonggi-do 16677 (KR)
(72) Inventor: HUH, Jinsuk, 16677 Suwon-si (KR); JANG, Dongyoung, 16677 Suwon-si (KR)
(74) Representative: Marks & Clerk LLP

(57) **Abstract**

An image sensor includes first and second pixels. The first pixel includes a first photodiode, a first transfer gate connected between the first photodiode and a first floating diffusion (FD) node, a first FD selection gate connected between a first node and the first FD node, a first lateral overflow integration capacitor (LOFIC) selection gate connected between the first FD node and a first LOFIC node, and a first capacitor connected between the first LOFIC node and a first reset voltage. The second pixel includes a second photodiode, a second transfer gate connected between the second photodiode and a second FD node, and a second FD selection gate connected between a second node electrically connected to the first node and the second FD node.

## Description

### TECHNICAL FIELD

Some example embodiments described herein relate to an image sensor, and more particularly, relate to an image sensor and/or an operation method thereof.

### BACKGROUND

An image sensor obtains image information about an external object by converting a light reflected from the external object into an electrical signal. An electronic device which includes the image sensor may display an image in a display panel by using the obtained image information.

The image sensor may be mounted in various types of electronic devices. For example, the electronic device which includes the image sensor may be included as a component of various types of electronic devices such as a smartphone, a tablet personal computer (PC), a laptop PC, and/or a wearable device.

### SUMMARY

Some example embodiments provide an image sensor with improved performance and improved reliability and/or an operation method thereof.

According to some example embodiments, an image sensor includes a first pixel including a first photodiode, the first pixel configured to output a first output voltage corresponding to a light incident onto the first photodiode, and a second pixel including a second photodiode, the second pixel configured to output a second output voltage corresponding to the light incident onto the second photodiode. The first pixel further includes a first transfer gate connected between the first photodiode and a first floating diffusion (FD) node, a first FD selection gate connected between a first node and the first FD node, a first lateral overflow integration capacitor (LOFIC) selection gate connected between the first FD node and a first LOFIC node, and a first capacitor connected between the first LOFIC node and a first reset voltage. The second pixel further includes a second transfer gate connected between the second photodiode and a second FD node, a second FD selection gate connected between a second node electrically connected to the first node and the second FD node, a second LOFIC selection gate connected between the second FD node and a second LOFIC node, and a second capacitor connected between the second LOFIC node and the first reset voltage.

According to some example embodiments, an operation method of an image sensor is provided, the image sensor including a first pixel and a second pixel, the first pixel including a first photodiode, a first floating diffusion (FD) node, a first shared floating diffusion (SFD) circuit connected to the first FD node, and a first lateral overflow integration capacitor (LOFIC) circuit connected to the first FD node, and the second pixel including a second photodiode, a second FD node, a second SFD circuit connected to the second FD node, and a second LOFIC circuit connected to the second FD node. The operation method includes electrically connecting the first FD node and the second FD node by disabling the first LOFIC circuit and enabling the first SFD circuit and performing a sensing operation on the first pixel based on the first and second FD nodes, in a shared mode, and electrically connecting the first FD node and a first capacitor included in the first LOFIC circuit by disabling the first SFD circuit and enabling the first LOFIC circuit and performing a sensing operation on the first pixel based on the first FD node and the first capacitor, in an LOFIC mode. During the sensing operation on the first pixel in the shared mode, the first capacitor is electrically separated from the first FD node. During the sensing operation on the first pixel in the LOFIC mode, the second FD node is electrically separated from the first FD node.

According to some example embodiments, an image sensor includes a first photodiode, a first transfer gate connected between the first photodiode and a first floating diffusion (FD) node, a first shared floating diffusion (SFD) circuit connected to the first FD node, a first lateral overflow integration capacitor (LOFIC) circuit connected to the first FD node and including a first capacitor, a first source follower including a first gate terminal connected to the first FD node, and a first selection gate connected between the first source follower and a first column line. The image sensor is configured to operate in a shared mode and in a LOFIC mode, such that, in the shared mode, the first SFD circuit is configured to electrically connect the first FD node to a second FD node different from the first FD node, and in the LOFIC mode of the image sensor, the first LOFIC circuit is configured to electrically connect the first FD node to the first capacitor.

According to some example embodiments, an image sensor includes a first pixel including a first photodiode, a first floating diffusion (FD) node, and a first capacitor, and a second pixel including a second photodiode, a second FD node, and a second capacitor. The image sensor is configured to operate in a shared mode and in a lateral integration overflow capacitor (LOFIC) mode such that, in the shared mode, during a sensing operation on the first pixel, the image sensor is configured to electrically connect the first FD node of the first pixel to the second FD node of the second pixel to vary a conversion gain of the first pixel, and in the lateral overflow integration capacitor (LOFIC) mode, during the sensing operation on the first pixel, the image sensor is configured to electrically connect the first FD node to the first capacitor of the first pixel to vary the conversion gain of the first pixel.

According to some example embodiments, there is provided an image sensor comprising a first pixel and a second pixel adjacent to the first pixel. The first pixel may further include a first floating diffusion (FD) node, a first lateral overflow integration capacitor (LOFIC) selection gate connected between the first FD node and a first LOFIC node, and a first capacitor connected between the first LOFIC node and a first reset node configured to be at a first reset voltage. The second pixel may further include a second FD node, a second LOFIC selection gate connected between the second FD node and a second LOFIC node, and a second capacitor connected between the second LOFIC node and a second reset node configured to be at the first reset voltage.

In some example embodiments, a capacitance of the first capacitor is the same as a capacitance of the second capacitor.

In some example embodiments, the first capacitor includes at least one of a metal-insulator-metal (MIM) capacitor, a metal-oxide-metal (MOM) capacitor, a metal-oxide-semiconductor capacitor (MOSCAP), a polysilicon capacitor, and a DRAM capacitor.

In some example embodiments, the second capacitor includes at least one of a metal-insulator-metal (MIM) capacitor, a metal-oxide-metal (MOM) capacitor, a metal-oxide-semiconductor capacitor (MOSCAP), a polysilicon capacitor, and a DRAM capacitor.

At least some of the above and other features of the invention are set out in the claims.

### BRIEF DESCRIPTION OF THE FIGURES

The above and other objects and features of some example embodiments will become apparent by describing in detail embodiments thereof with reference to the accompanying drawings.
FIG. 1 is a diagram illustrating an image system according to some example embodiments.
FIG. 2 is a circuit diagram illustrating an example of a pixel included in an image sensor.
FIG. 3 is a block diagram illustrating an image sensor of FIG. 1.
FIG. 4 is a diagram illustrating a pixel array of FIG. 3.
FIG. 5 is a circuit diagram illustrating some pixels of a pixel array of FIG. 4.
FIG. 6 is a flowchart illustrating an operation of an image sensor of FIG. 3.
FIGS. 7A to 7C are diagrams for describing how first and second pixels FIG. 5 operate in a shared mode.
FIGS. 8A to 8C are diagrams for describing how an image sensor of FIG. 3 operates in an LOFIC mode.
FIGS. 9A and 9B are diagrams for describing how an image sensor of FIG. 3 operates in an LOFIC mode.
FIG. 10 is a timing diagram for describing an operation of an image sensor of FIG. 3.
FIG. 11 is a circuit diagram illustrating some pixels of a pixel array of FIG. 4 in detail.
FIG. 12 is a circuit diagram illustrating some pixels of a pixel array of FIG. 4.
FIG. 13 is a circuit diagram illustrating some pixels of a pixel array of FIG. 4 in detail.
FIG. 14 is a circuit diagram illustrating some pixels of a pixel array of FIG. 4.
FIG. 15 is a diagram illustrating some pixels included in a pixel array of FIG. 2.
FIG. 16 is a diagram illustrating some pixels included in a pixel array of FIG. 2.
FIG. 17 is a diagram illustrating some pixels of a pixel array of FIG. 2.
FIG. 18 is a diagram illustrating a stacked structure of an image sensor of FIG. 2.
FIG. 19 is a diagram illustrating a stacked structure of an image sensor of FIG. 2.
FIG. 20 is a diagram for describing a pixel included in an image sensor of a stacked structure of FIG. 19.
FIGS. 21A to 21E are diagrams illustrating some pixels included in an image sensor of a stacked structure of FIG. 19.
FIG. 22 is a block diagram of an electronic device including a multi-camera module.
FIG. 23 is a block diagram illustrating a camera module of FIG. 22 in detail.

### DETAILED DESCRIPTION

Below, some examples will be described in detail and clearly to such an extent that a person of ordinary skill in the art may easily carry out the example embodiments.

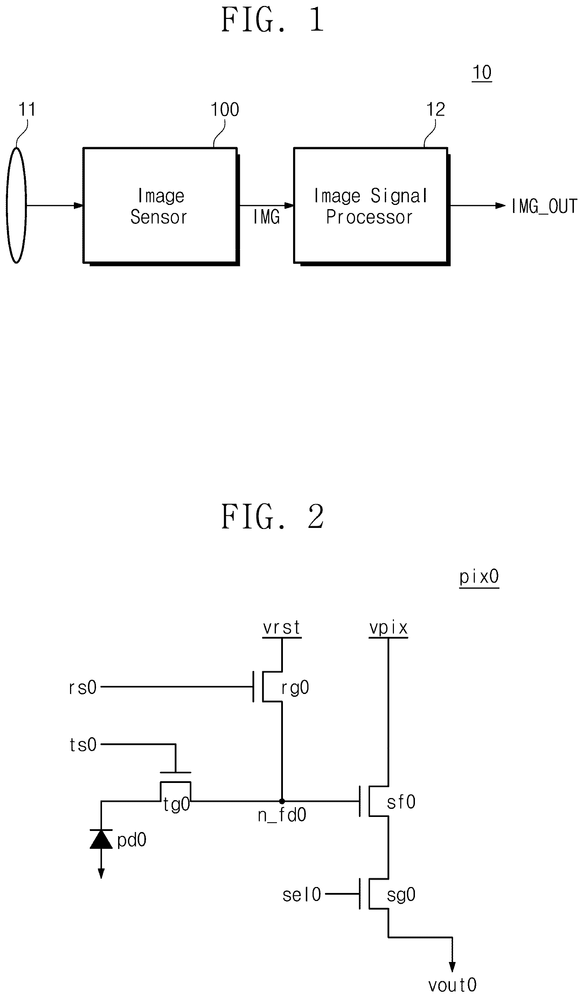

FIG. 1 is a diagram illustrating an image system according to some example embodiments. FIG. 2 is a circuit diagram illustrating an example of a pixel included in an image sensor. Referring to FIG. 1, an image system 10 may include a lens 11, an image sensor 100, and an image signal processor 12. In some example embodiments, the image system 10 may be implemented as a part of various electronic devices such as one or more of a camera, a smartphone, a wearable device, an Internet of Things (IoT) device, home appliances, a tablet personal computer (PC), a personal digital assistant (PDA), a portable multimedia player (PMP), a navigation system, a drone, an advanced drivers assistance system (ADAS), a traffic surveillance camera, and a CCTV. Alternatively or additionally, the image system 10 may be installed in an electronic device which is provided as a part of one or more of a vehicle, furniture, manufacturing equipment, a door, and various kinds of measuring instruments.

The lens 11 may receive a light reflected from an external object. The lens 11 may be or may include one or more of a convex lens, a concave lens, or a concave-convex lens, however example embodiments are not limited thereto. The image sensor 100 may generate an electrical signal, based on the light received through the lens 11. For example, the image sensor 100 may be implemented with a complementary metal oxide semiconductor (CMOS) image sensor. However, example embodiments are not limited thereto. For example, the image sensor 100 may be implemented based on various image sensors such as a dynamic vision sensor (DVS) and/or a digital pixel sensor (DPS). The image sensor 100 may output an image IMG, based on the generated electrical signal.

In some example embodiments, the image sensor 100 may include a plurality of pixels, and each of the plurality of pixels may generate photoelectrons based on the light received and/or incident through the lens 11. Each of the plurality of pixels may store the generated photoelectrons at a floating diffusion (FD) node and may output an electrical signal corresponding to a voltage level of the FD node.

As an example, as illustrated in FIG. 2, a 0-th pixel pix0 may include a 0-th photodiode pd0, a 0-th transfer gate tg0, a 0-th source follower sf0, a 0-th selection gate sg0, and a 0-th reset gate rg0. The 0-th photodiode pd0 may generate photoelectrons, based on an incident light. The 0-th transfer gate tg0 may transfer the photoelectrons generated by the 0-th photodiode pd0 to a 0-th FD node n_fd0 in response to a 0-th transfer signal ts0. The 0-th source follower sf0 may transfer a pixel voltage vpix in response to a level of the 0-th FD node n_fd0. The 0-th selection gate sg0 may output a 0-th output voltage vout0 in response to a 0-th selection signal sel0. The 0-th reset gate rg0 may reset the 0-th FD node n_fd0 with a reset voltage vrst or a level corresponding to the reset voltage vrst in response to a 0-th reset signal rs0. As described above, the 0-th pixel pix0 may have the 0-th FD node n_fd0 of a fixed size; in this case, the quality or reliability of the 0-th output voltage vout0 may be reduced depending on an external environment (e.g., low illuminance or high illuminance).

Although FIG. 2 illustrates each of the transistor gates tg0, rg0, n_fd0, sf0, and sg0 as being a portions of an NMOS transistor, example embodiments are not limited thereto. Alternatively or additionally, an electrical and/or physical characteristic of at least one of transistors may be the same, or different, from an electrical and/or physical characteristic of others of the transistors. Example embodiments are not limited thereto.

According to some example embodiments, the plurality of pixels included in the image sensor 100 may operate in a shared mode or a lateral overflow integration capacitor (LOFIC) mode.

The shared mode may refer to an operation mode in which each of a plurality of pixels included in an image sensor shares an FD node of an adjacent pixel such that a conversion gain of the FD node is controlled. For example, in the shared mode, each of the plurality of pixels may share the FD node with an adjacent pixel. In this case, as a pixel capacitance of each of the plurality of pixels increases, a conversion gain (CG) of each pixel may be controlled. In some example embodiments, the pixel capacitance may indicate a capacitance of the FD node (e.g., a parasitic capacitance of the FD node) and/or a capacitor such as a designed capacitor configured to store or integrate photoelectrons generated by each pixel. The image sensor 100 may control the conversion gain to obtain a high conversion gain (HCG) image or a low conversion gain (LCG) image. The image sensor 100 may generate a high dynamic range (HDR) image by combining the obtained images.

In the LOFIC mode, each of the plurality of pixels may electrically connect a physically formed capacitor, e.g., a physically formed planar capacitor and/or a stacked capacitor with a similar structure to a DRAM capacitor, with the FD node. In this case, as a pixel capacitance of each of the plurality of pixels increases, the conversion gain (CG) may be controlled. The image sensor 100 may control the conversion gain to obtain a high conversion gain (HCG) image or a low conversion gain (LCG) image. The image sensor 100 may generate a high dynamic range (HDR) image by combining the obtained images.

In some example embodiments, the capacitance of the capacitor used in the LOFIC mode may be greater than the capacitance of the FD node of the pixel. For example, in a relatively high illuminance environment, the image sensor 100 may operate in the LOFIC mode; in a relatively low illuminance environment, the image sensor 100 may operate in the shared mode. In this case, the quality of image may be improved in various external environments. Alternatively, because the capacitance of the capacitor used in the LOFIC mode is greater than the capacitance of the FD node, an image depth (e.g., a bit depth) may become deeper. As an example, in the LOFIC mode, each pixel may have a 14-bit or more image depth; in the shared mode, each pixel may have a 12-bit to 14-bit image depth. A structure and an operation of the image sensor 100 or a pixel according to some example embodiments will be described in detail with reference to the following drawings.

The image signal processor 12 may receive the image IMG from the image sensor 100 and may perform various image signal processing operations on the received image IMG to generate an output image IMG_OUT. In some example embodiments, the image signal processing operations may include one or more of various signal processing operations for improving the quality of image, such as one or more of a de-noising operation, a tone-mapping operation, a detail enhancing operation, a white balancing operation, a gamma correction operation, a de-mosaic operation, a sharping operation, and a color conversion operation.

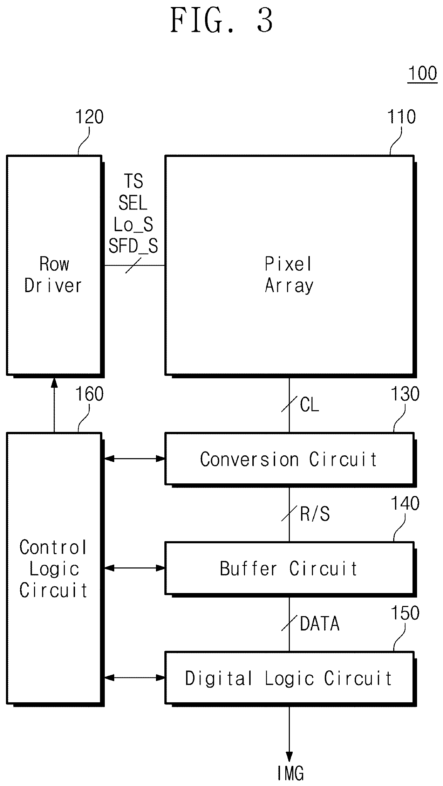

FIG. 3 is a block diagram illustrating an image sensor of FIG. 1. Referring to FIGS. 1 and 3, the image sensor 100 may include a pixel array 110, a row driver 120, a conversion circuit 130, a buffer circuit 140, a digital logic circuit 150, and a control logic circuit 160.

The pixel array 110 may include a plurality of pixels arranged along rows and columns. Each of the plurality of pixels may receive various control signals (e.g., TS, SEL, Lo_S, and SFD_S) from the row driver 120 and may operate in response to the received control signals.

As will be described later, each of the plurality of pixels may include a shared floating diffusion (SFD) circuit and a lateral overflow integrate capacitor (LOFIC) circuit. In the shared mode, each of (or at least some of) the plurality of pixels may operate in response to an SFD control signal SFD_S; in the LOFIC mode, each of (or at least some of) the plurality of pixels may operate in response to an LOFIC control signal Lo_S. A structure and an operation of the plurality of pixels will be described in detail with reference to the following drawings.

The row driver 120 may generate various control signals (e.g., one or more of TS, SEL, Lo_S, and SFD_S) for controlling the plurality of pixels included in the pixel array 110. For example, the row driver 120 may generate various control signals (e.g., one or more of TS, SEL, Lo_S, and SFD_S) such that the SFD circuit of each pixel is enabled in the shared mode and the LOFIC circuit of each pixel is enabled in the LOFIC mode.

The conversion circuit 130 may be connected to the pixel array 110 through a plurality of column lines CL. The conversion circuit 130 may receive a plurality of output voltages from the plurality of pixels of the pixel array 110 through the plurality of column lines CL. The conversion circuit 130 may convert the received output voltages into digital signals. In some example embodiments, the conversion circuit 130 may include an analog-to-digital converter (ADC) configured to convert an output voltage into a digital signal and a ramp signal generator. In some example embodiments, the conversion circuit 130 may convert an output voltage into a digital signal based on correlated double sampling (CDS).

The buffer circuit 140 may be configured to buffer the digital signals from the conversion circuit 130. In some example embodiments, the buffer circuit 140 may include memories configured to store the digital signals as data "DATA". The memories may be implemented with a dynamic random access memory (DRAM) and/or static random access memory (SRAM), but example embodiments are not limited thereto.

The digital logic circuit 150 may receive the data "DATA" from the buffer circuit 140. The digital logic circuit 150 may output image data IMG by performing signal processing for the data "DATA". For example, the digital logic circuit 150 may include an HDR module configured to perform signal processing for high dynamic range (HDR) implementation for the data "DATA". The HDR module of the digital logic circuit 150 may perform HDR signal processing for the data "DATA" and may output the image data IMG to which the HDR is applied. In some example embodiments, the digital logic circuit 150 may be configured to perform at least some of various operations of the image signal processor 12 of FIG. 1.

The control logic circuit 160 may control all the operations of the image sensor 100. For example, the control logic circuit 160 may be configured to control the remaining components 120, 130, 140, 150, etc. such that the image sensor 100 performs a sensing operation. In some example embodiments, under control of an external device (e.g., one or more of a host, an AP, or a CPU), the control logic circuit 160 may control an operation mode (e.g., the shared mode or the LOFIC mode) of the image sensor 100.

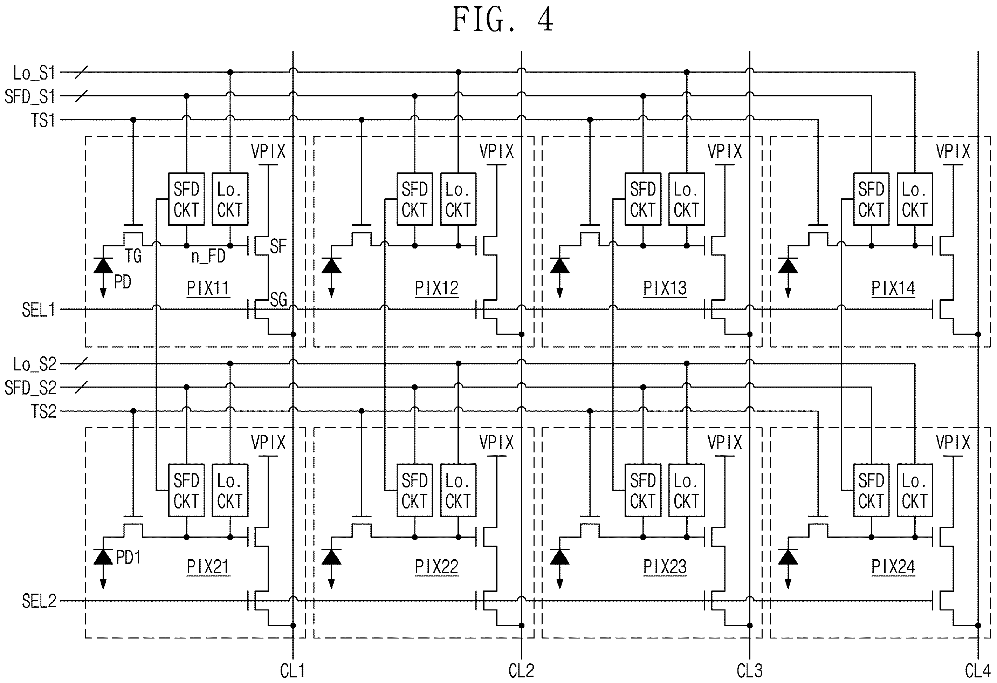

FIG. 4 is a diagram illustrating a pixel array of FIG. 3. Below, the term "gate" is used to describe components such as a transfer gate, a selection gate, or a reset gate. Unless otherwise defined, the "gate" used herein may refer to a transistor configured to perform a specific operation or function. For example, the transfer gate may be or may include (or be included in) a transistor configured to be turned on or turned off in response to a transfer signal. The reset gate may be or may include (or be included in) a transistor configured to be turned on or turned off in response to a reset signal. It may be understood that any other gate(s) also is a transistor configured to operate in response to a specific signal.

Referring to FIGS. 3 and 4, the pixel array 110 may include a plurality of pixels PIX11 to PIX24. Each of the plurality of pixels PIX11 to PIX24 may be configured to output an output voltage corresponding to the light incident from the outside. In FIG. 4, for brevity of drawing, eight pixels PIX11 to PIX24 are illustrated, but example embodiments are not limited thereto. For example, the pixel array 110 may further include other pixels arranged along a plurality of rows and a plurality of columns.

The plurality of pixels PIX11 to PIX24 may be arranged in row and column directions. Pixels located at the same row may share the same control signals. For example, the pixels PIX11 to PIX14 located at the first row may share a first transfer signal TS1, a first selection signal SEL1, a first shared floating diffusion (SFD) control signal SFD_S1, and a first LOFIC control signal Lo_S1. The pixels PIX21 to PIX24 located at the second row may share a second transfer signal TS2, a second selection signal SEL2, a second SFD control signal SFD_S2, and a second LOFIC control signal Lo_S2. Although each of the transistors are illustrated as NMOS transistors, example embodiments are not limited thereto, and at least some of the transistors may be PMOS transistors.

As an example, the 11-th pixel PIX11 may include a photodiode PD, a transfer gate TG, a source follower SF, a selection gate SG, an SFD circuit SFD_CKT, and an LOFIC circuit Lo_CKT. The transfer gate TG may be connected between the photodiode PD and an FD node n_FD and may operate in response to the first transfer signal TS1. The source follower SF and the selection gate SG may be connected in series between a pixel voltage VPIX and a first column line CL1, the source follower SF may operate in response to a level of the FD node n_FD, and the selection gate SG may operate in response to the first selection signal SEL1. As an example, a gate terminal (in this case, the gate terminal referring to a gate terminal of a transistor) of the source follower SF may be connected to the FD node n_FD. The SFD circuit SFD_CKT may be connected to the FD node n_FD and may operate in response to the first SFD control signal SFD_S1. The LOFIC circuit Lo_CKT may be connected to the FD node n_FD and may operate in response to the first LOFIC control signal Lo_S1. Because the remaining pixels PIX12 to PIX24 are similar in structure except for control signals, additional description associated with the remaining pixels PIX12 to PIX24 will be omitted to avoid redundancy.

In some example embodiments, the pixels PIX11 to PIX14 of the first row may share the FD nodes n_FD of the pixels PIX21 to PIX24 of the second row through the SFD circuit SFD_CKT. For example, in the shared mode, the SFD circuit SFD_CKT of the 11-th pixel PIX11 may operate in response to the first SFD control signal SFD_S1. In this case, the FD node n_FD of the 11-th pixel PIX11 may be connected to the FD node n_FD of the 21-th pixel PIX21 adjacent thereto, and thus, the pixel capacitance of each of the pixels PIX11 to PIX14 of the first row may increase. In the operation of the 11-th pixel PIX11, as the pixel capacitance increases, the conversion gain of the 11-th pixel PIX11 may be varied.

In some example embodiments, in the LOFIC mode, the LOFIC circuit Lo_CKT of each of the plurality of pixels PIX11 to PIX24 may be enabled, and a capacitor included in the LOFIC circuit Lo_CKT may be connected to the FD node n_FD. In this case, as the pixel capacitance of each of the plurality of pixels PIX11 to PIX24 increases, the conversion gain of each of the plurality of pixels PIX11 to PIX24 may be varied.

In some example embodiments, in the shared mode, when each pixel shares the FD node n_FD with an adjacent pixel, the pixel capacitance may have a first value. In the LOFIC mode, when the FD node n_FD of each pixel is connected to the capacitor of the LOFIC circuit Lo_CKT, the pixel capacitance may have a second value greater than the first value. Accordingly, the conversion gain of each pixel may be controlled depending on the operation mode of the image sensor 100.

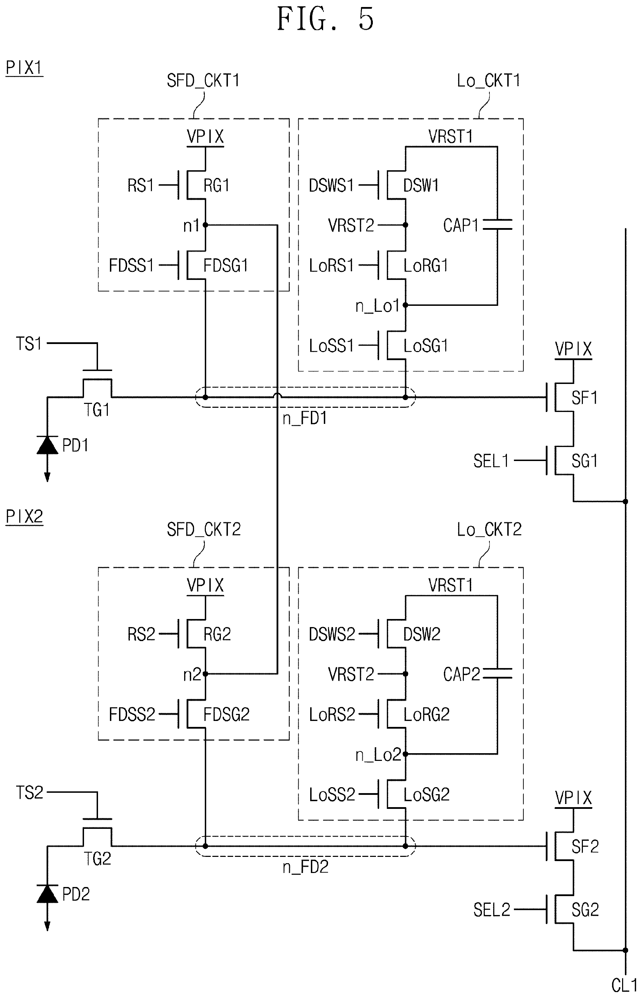

FIG. 5 is a circuit diagram illustrating some pixels of a pixel array of FIG. 4. Referring to FIGS. 3 to 5, the pixel array 110 may include a first pixel PIX1 and a second pixel PIX2. In some example embodiments, the first and second pixels PIX1 and PIX2 may respectively correspond to the 11-th and 21-th pixels PIX11 and PIX21 of FIG. 4. Alternatively, the first pixel PIX1 may correspond to one of the pixels PIX11 to PIX14 of the first row, and the second pixel PIX2 may correspond to one of the pixels PIX21 to PIX24 of the second row.

The first pixel PIX1 may include a first photodiode PD1, a first transfer gate TG1, a first source follower SF1, a first selection gate SG1, a first SFD circuit SFD_CKT1, and a first LOFIC circuit Lo_CKT1. The first transfer gate TG1 may be connected between the first photodiode PD1 and a first FD node n_FD1 and may operate in response to the first transfer signal TS1. The first source follower SF1 may be connected between the pixel voltage VPIX and the first selection gate SG1 and may operate in response to a level of the first FD node n_FD1. As an example, a gate terminal (in this case, the gate terminal referring to a metal and/or polysilicon gate terminal of a transistor) of the first source follower SF1 may be connected to the first FD node n_FD1. The first selection gate SG1 may be connected between the first source follower SF1 and the first column line CL1 and may operate in response to the first selection signal SEL1.

The first SFD circuit SFD_CKT1 may be connected to the first FD node n_FD1 and may operate in response to a first SFD control signal SFD_S1. For example, the first SFD control signal SFD_S1 may include a first FD selection signal FDSS1 and a first reset signal RS1. The first SFD circuit SFD_CKT1 may include a first FD selection gate FDSG1 and a first reset gate RG1. The first FD selection gate FDSG1 may be connected between a first node n1 and the first FD node n_FD1 and may operate in response to the first FD selection signal FDSS1. The first reset gate RG1 may be connected between the pixel voltage VPIX and the first node n1 and may operate in response to the first reset signal RS1. In some example embodiments, the first node n1 may be electrically connected to a second node n2 of the second pixel PIX2.

The first LOFIC circuit Lo_CKT1 may be connected to the first FD node n_FD1 and may operate in response to the first LOFIC control signal Lo_S1. For example, the first LOFIC control signal Lo_S1 may include a first LOFIC selection signal LoSS1, a first LOFIC reset signal LoRS1, and a first discharge signal DSWS1. The first LOFIC circuit Lo_CKT1 may include a first LOFIC selection gate LoSG1, a first LOFIC reset gate LoRG1, a first discharge switch DSW1, and a first capacitor CAP1. The first LOFIC selection gate LoSG1 may be connected between the first FD node n_FD1 and a first LOFIC node n_Lo1 and may operate in response to the first LOFIC selection signal LoSS1. The first LOFIC reset gate LoRG1 may be connected between a second reset voltage VRST2 and the first LOFIC node n_Lo1 and may operate in response to the first LOFIC reset signal LoRS1. The first discharge switch DSW1 may be connected between the second reset voltage VRST2 and a first reset voltage VRST1 and may operate in response to the first discharge signal DSWS1. The first capacitor CAP1 may be connected between the first reset voltage VRST1 and the first LOFIC node n_Lo1.

The second pixel PIX2 may include a second photodiode PD2, a second transfer gate TG2, a second source follower SF2, a second selection gate SG2, a second SFD circuit SFD_CKT2, and a second LOFIC circuit Lo_CKT2. Each respective gate of the first pixel PIX1 may have the same, or different, electrical and/or physical characteristics as those of the second pixel PIX2, however example embodiments are not limited thereto.

The second transfer gate TG2 may be connected between the second photodiode PD2 and a second FD node n_FD2 and may operate in response to the second transfer signal TS2. The second source follower SF2 may be connected between the pixel voltage VPIX and the second selection gate SG2 and may operate in response to a level of the second FD node n_FD2. The second selection gate SG2 may be connected between the second source follower SF2 and the first column line CL1 and may operate in response to a second selection signal SEL2.

The second SFD circuit SFD_CKT2 may be connected to the second FD node n_FD2 and may operate in response to the second SFD control signal SFD_S2. For example, the second SFD control signal SFD_S2 may include a second FD selection signal FDSS2 and a second reset signal RS2. The second SFD circuit SFD_CKT2 may include a second FD selection gate FDSG2 and a second reset gate RG2. The second FD selection gate FDSG2 may be connected between the second FD node n_FD2 and the second node n2 and may operate in response to the second FD selection signal FDSS2. The second reset gate RG2 may be connected between the second node n2 and the pixel voltage VPIX and may operate in response to the second reset signal RS2. In some example embodiments, the second node n2 may be electrically connected to the first node n1 of the first pixel PIX1.

The second LOFIC circuit Lo_CKT2 may be connected to the second FD node n_FD2 and may operate in response to the second LOFIC control signal Lo_S2. For example, the second LOFIC control signal Lo_S2 may include a second LOFIC selection signal LoSS2, a second LOFIC reset signal LoRS2, and a second discharge signal DSWS2. The second LOFIC circuit Lo_CKT2 may include a second LOFIC selection gate LoSG2, a second LOFIC reset gate LoRG2, a second discharge switch DSW2, and a second capacitor CAP2. The second LOFIC selection gate LoSG2 may be connected between the second FD node n_FD2 and a second LOFIC node n_Lo2 and may operate in response to the second LOFIC selection signal LoSS2. The second LOFIC reset gate LoRG2 may be connected between the second LOFIC node n_Lo2 and the second reset voltage VRST2 and may operate in response to the second LOFIC reset signal LoRS2. The second discharge switch DSW2 may be connected between the first reset voltage VRST1 and the second reset voltage VRST2 and may operate in response to the second discharge signal DSWS2. The second capacitor CAP2 may be connected between the first reset voltage VRST1 and the second LOFIC node n_Lo2.

In some example embodiments, the pixel voltage VPIX, the first reset voltage VRST1, and the second reset voltage VRST2 are illustrated individually, but the pixel voltage VPIX, the first reset voltage VRST1, and the second reset voltage VRST2 may have the same voltage level or different voltage levels. Alternatively or additionally, the pixel voltage VPIX, the first reset voltage VRST1, and the second reset voltage VRST2 may be individually controlled.

In some example embodiments, each of the first and second capacitors CAP1 and CAP2 may be or may include a metal-insulator-metal (MIM) capacitor, and in some cases may have the same or different capacitance. However, example embodiments are not limited thereto. For example, each of the first and second capacitors CAP1 and CAP2 may be implemented in various forms such as one or more of a metal-oxide-metal (MOM) capacitor, a metal-oxide-semiconductor capacitor (MOSCAP), a polysilicon capacitor, and a DRAM capacitor. In some example embodiments, in a process of forming capacitors included in the buffer circuit 140, the first and second capacitors CAP1 and CAP2 may also be formed. In some example embodiments, the first and second capacitors CAP1 and CAP2 may also be formed in the same processing scheme with process of forming capacitors included in the buffer circuit 140. However, example embodiments are not limited thereto.

In some example embodiments, in the shared mode of the image sensor 100, as the first FD node n_FD1 and the second FD node n_FD2 are electrically connected, a low conversion gain (LCG) may be implemented in the operation of the first pixel PIX1 or the second pixel PIX2.

For example, it is assumed that the first pixel PIX1 operates in the shared mode. In this case, the first FD selection gate FDSG1 is turned on in response to the first FD selection signal FDSS1, and the second FD selection gate FDSG2 is turned on in response to the second FD selection signal FDSS2. In this case, the first FD node n_FD1 may be electrically connected to the second FD node n_FD2 through the first FD selection gate FDSG1, the first node n1, the second node n2, and the second FD selection gate FDSG2. In the operation of the first pixel PIX1, because the conversion gain corresponds (or is inversely proportional) to a sum of capacitance of the first FD node n_FD1 and the second FD node n_FD2, the low conversion gain (LCG) may be implemented. In the shared mode, the first LOFIC circuit Lo_CKT1 of the first pixel PIX1 may be electrically separated from the first FD node n_FD1. For example, in the shared mode, the first LOFIC selection gate LoSG1 may be turned off in response to the first LOFIC selection signal LoSS1. In this case, the first capacitor CAP1 may be electrically separated from the first FD node n_FD1.

In some example embodiments, in the LOFIC mode of the image sensor 100, as the first FD node n_FD1 and the first capacitor CAP1 are electrically connected, the low conversion gain may be implemented in the operation of the first pixel PIX1. For example, it is assumed that the first pixel PIX1 operates in the LOFIC mode. In this case, the first LOFIC selection gate LoSG1 may be turned on in response to the first LOFIC selection signal LoSS1, and thus, the first FD node n_FD1 may be electrically connected to the first capacitor CAP1 through the first LOFIC selection gate LoSG1. In the operation of the first pixel PIX1, because the conversion gain corresponds (or is inversely proportional) to a sum of capacitance of the first FD node n_FD1 and the first capacitor CAP1, the low conversion gain (LCG) may be implemented. In some example embodiments, in the LOFIC mode, the first FD selection gate FDSG1 may be turned off in response to the first FD selection signal FDSS1, and thus, the first FD node n_FD1 of the first pixel PIX1 may be electrically separated from the second FD node n_FD2 of the second pixel PIX2 adjacent thereto.

In some example embodiments, the capacitance of the first capacitor CAP1 of the first pixel PIX1 may be relatively larger than the capacitance of the first FD node n_FD1 or the second FD node n_FD2. Accordingly, the low conversion gain of the first pixel PIX1 may have the first value in the shared mode, and the low conversion gain of the first pixel PIX1 may have the second value smaller than the first value in the LOFIC mode. For example, in the high-illuminance environment, as an image sensor operates in the LOFIC mode, the quality of image may be improved.

As described above, each of the first and second pixels PIX1 and PIX2 of the image sensor 100 may include the SFD circuit SFD_CKT and the LOFIC circuit Lo_CKT. The SFD circuit SFD_CKT and the LOFIC circuit Lo_CKT may be selectively enabled depending on the operation mode of the image sensor 100, and thus, the pixel capacitance (or conversion gain) of each of the first and second pixels PIX1 and PIX2 may be variously varied or controlled.

The first and second pixels PIX1 and PIX2 illustrated in FIG. 5 are provided as an example, and example embodiments are not limited thereto. An example in which the first and second pixels PIX1 and PIX2 are located at the same column and share the first column line CL1 is illustrated in FIG. 5; however, at least two pixels sharing the FD node in the shared mode may be located at different columns and may be connected to different column lines. Alternatively or additionally, at least two pixels sharing the FD node in the shared mode may not be physically adjacent to each other. For example, at least two pixels sharing the FD node may be located at the first row and the third row, and at least two other pixels sharing the FD node may be located at the second row and the fourth row. For example, the pixel location and arrangement may be variously varied.

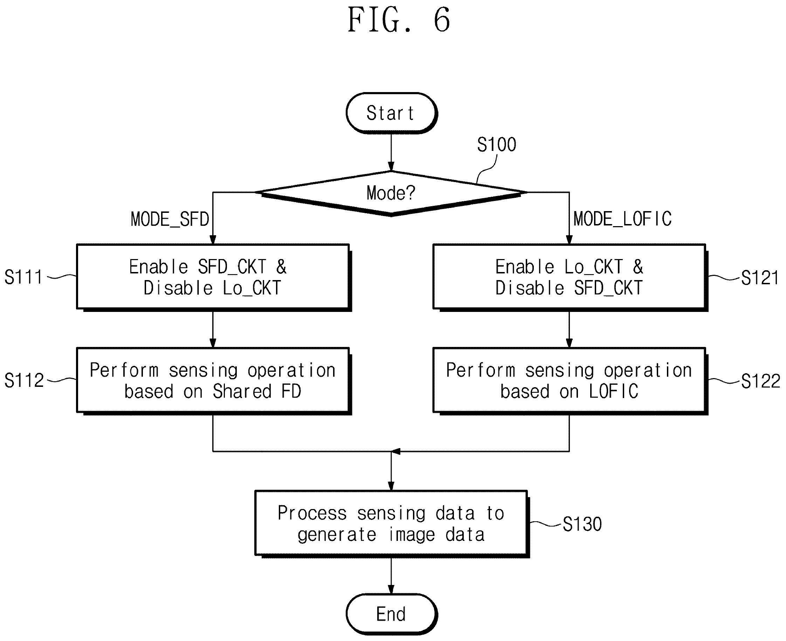

FIG. 6 is a flowchart illustrating an operation of an image sensor of FIG. 3. Referring to FIGS. 3, 5, and 6, in operation S100, the image sensor 100 may determine the operation mode. For example, the image sensor 100 may receive information about the operation mode from the external device (e.g., an AP and/or a CPU). The image sensor 100 may determine the operation mode based on the received information. Alternatively or additionally, the image sensor 100 may determine the operation mode based on an external illuminance.

When the determined operation mode is the shared mode (MODE_SFD), in operation S111, the image sensor 100 may enable the SFD circuit SFD_CKT of each of the plurality of pixels and may disable the LOFIC circuit Lo_CKT of each of the plurality of pixels. For example, the image sensor 100 may disable the LOFIC circuit Lo_CKT by controlling the LOFIC selection signal LoSS such that the LOFIC selection gate LoSG of the LOFIC circuit Lo_CKT of each of the plurality of pixels is turned off. The image sensor 100 may enable the SFD circuit SFD_CKT, by turning on the FD selection gate FDSG of the SFD circuit SFD_CKT, in synchronization with the operation timing of each of the plurality of pixels.

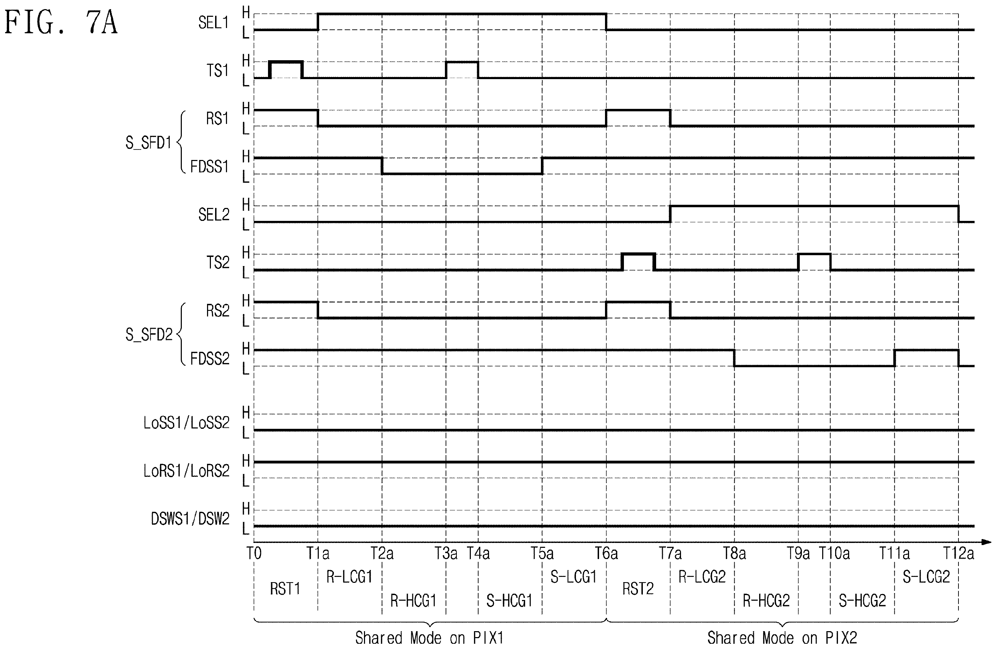

In operation S112, the image sensor 100 may perform the sensing operation based on the shared mode. For example, the image sensor 100 may perform the high conversion gain sensing operation through the FD node of each of the plurality of pixels and may perform low conversion gain sensing operation through the FD node of each of the plurality of pixels and the FD node of an adjacent pixel. The sensing operation based on the shared mode will be described in detail with reference to FIGS. 7A to 7C.

When the determined operation mode is the LOFIC mode (MODE_LOFIC), in operation S121, the image sensor 100 may enable the LOFIC circuit Lo_CKT of each of the plurality of pixels and may disable the SFD circuit SFD_CKT of each of the plurality of pixels. For example, the image sensor 100 may disable the SFD circuit SFD_CKT by controlling the FD selection signal FDSS such that the FD selection gate FDSG of the SFD circuit SFD_CKT of each of the plurality of pixels is turned off. The image sensor 100 may enable the LOFIC circuit Lo_CKT, by turning on the LOFIC selection gate LoSG of the LOFIC circuit Lo_CKT, in synchronization with the operation timing of each of the plurality of pixels.

In some example embodiments, the sensing operation based on the shared mode and the sensing operation based on the LOFIC mode will be described in detail with reference to the following drawings.

In operation S130, the image sensor 100 may process sensing data to generate the image data IMG. For example, reset values and signal values of different conversion gains may be sampled through the sensing operation based on the shared mode in operation S112 and the sensing operation based on the LOFIC mode in operation S122. The image sensor 100 may perform signal processing for the reset values and the signal values of different conversion gains and may generate the image data IMG to which the HDR is applied.

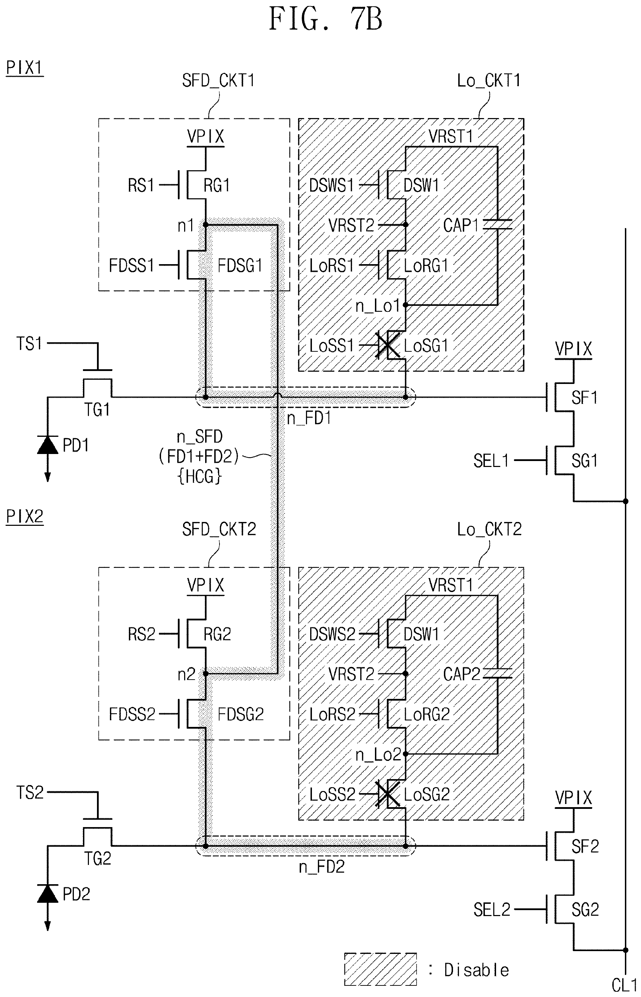

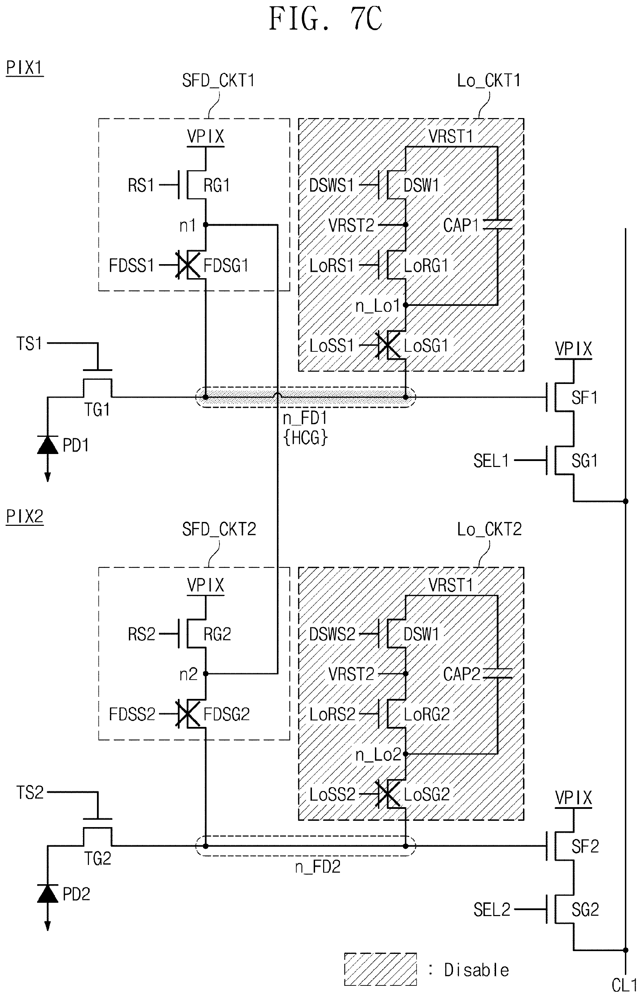

FIGS. 7A to 7C are diagrams for describing how first and second pixels of FIG. 5 operate in a shared mode. An operation of the first and second pixels in the shared mode will be described with reference to the timing diagram of FIG. 7A, a high conversion gain (HCG) operation of the first pixel in the shared mode will be described with reference to FIG. 7B, and a low conversion gain (LCG) operation of the first pixel in the shared mode will be described with reference to FIG. 7C. The configuration of the first and second pixels PIX1 and PIX2 of FIGS. 7B and 7C are described with reference to FIG. 5, and thus, additional description will be omitted to avoid redundancy.

Below, the description will be given as each control signal is at a high level "H" or a low level "L". The high level "H" may be a high voltage enough to turn on the corresponding gate or transistor, and the low level "L" may be a low voltage enough to turn off the corresponding gate or transistor, for example, if each of the transistors are NMOS transistors.

Referring to FIGS. 3 and 5 to 7C, in the shared mode, the image sensor 100 may sequentially perform the sensing operation on the first pixel PIX1 and the sensing operation on the second pixel PIX2. In this case, the first LOFIC circuit Lo_CKT1 of the first pixel PIX1 and the second LOFIC circuit Lo_CKT2 of the second pixel PIX2 may be disabled. For example, in the shared mode, while the sensing operations on the first pixel PIX1 and the second pixel PIX2 are performed (e.g., in a period from T0 to T12a), the first and second LOFIC selection signals LoSS1 and LoSS2 may maintain the low level "L", the first and second LOFIC reset signals LoRS1 and LoRS2 may maintain the high level "H", and the first and second discharge signals DSWS1 and DSWS2 may maintain the low level "L". In this case, the first and second LOFIC selection gates LoSG1 and LoSG2 may be respectively turned off in response to the first and second LOFIC selection signals LoSS1 and LoSS2 of the low level "L". According to the above description, the first capacitor CAP1 of the first LOFIC circuit Lo_CKT1 may be electrically separated from the first FD node n_FD1, and the second capacitor CAP2 of the second LOFIC circuit Lo_CKT2 may be electrically separated from the second FD node n_FD2.

During the low conversion gain sampling operation (e.g., R-LCG1, S-LCG1, R-LCG2, or S-LCG2) in the shared mode, the first FD node n_FD1 of the first pixel PIX1 and the second FD node n_FD2 of the second pixel PIX2 may be electrically connected.

In the period from T0 to T1a, the image sensor 100 may perform a first reset operation RST1 on the first pixel PIX1. For example, in the period from T0 to T1a, the first selection signal SEL1 may be at the low level "L", the first transfer signal TS1 may be at the high level "H", the first reset signal RS1 may be at the high level "H", the first FD selection signal FDSS1 may be at the high level "H", the second selection signal SEL2 may be at the low level "L", the second transfer signal TS2 may be at the low level "L", the second reset signal RS2 may be at the high level "H", and the second FD selection signal FDSS2 may be at the high level "H". In this case, as the first and second FD selection gates FDSG1 and FDSG2 are turned on in response to the first and second FS selection signals FDSS1 and FDSS2, the first and second FD nodes n_FD1 and n_FD2 may be electrically connected. As the first transfer gate TG1 is turned on in response to the first transfer signal TS1 of the high level "H" and the first and second reset gates RG1 and RG2 are turned on in response to the first and second reset signals RS1 and RS2 of the high level "H", the first and second FD nodes n_FD1 and n_FD2 and the first photodiode PD1 may be reset with the pixel voltage VPIX or the level corresponding to the pixel voltage VPIX.

Afterwards, in a period from T1a to T2a, the image sensor 100 may sample a reset value R-LCG1 of a first low conversion gain in association with the first pixel PIX1. For example, in the period from T1a to T2a, the first selection signal SEL1 may be at the high level "H", the first reset signal RS1 may be at the low level "L", and the second reset signal RS2 may be at the low level "L". In this case, the first and second reset gates RG1 and RG2 may be turned off in response to the first and second reset signals RS1 and RS2 of the low level "L". The first selection gate SG1 may be turned on in response to the first selection signal SEL1 of the high level "H". Because the first and second FD nodes n_FD1 and n_FD2 are in a state of being electrically connected and reset with the pixel voltage VPIX, an output voltage corresponding to a sum of voltage of the first and second FD nodes n_FD1 and n_FD2 may be output through the first column line CL1. For example, illustrated in FIG. 7B, as the first and second LOFIC selection gates LoSG1 and LoSG2 are turned off and the first and second FD selection gates FDSG1 and FDSG2 are turned on, the first and second FD nodes n_FD1 and n_FD2 may be electrically connected. The electrically connected first and second FD nodes n_FD1 and n_FD2 may be called a shared FD node n_SFD. Because the capacitance of the shared FD node n_SFD corresponds to a sum of the capacitances of the first and second FD nodes n_FD1 and n_FD2, the low conversion gain (LCG) may be implemented. The conversion circuit 130 of the image sensor 100 may perform a sampling operation on the output voltage of the first column line CL1 to generate the reset value R-LCG1 of the first low conversion gain. For example, in association with the first pixel PIX1, the conversion circuit 130 of the image sensor 100 may sample the reset value R-LCG1 of the first low conversion gain based on the voltage of the shared FD node n_SFD.

Afterwards, in a period from T2a to T3a, the image sensor 100 may sample a reset value R-HCG1 of a first high conversion gain in association with the first pixel PIX1. For example, in the period from T2a to T3a, the first FD selection signal FDSS1 may be at the low level "L". The first FD selection gate FDSG1 may be turned off in response to the first FD selection signal FDSS1 of the low level "L". In this case, the first FD node n_FD1 may be electrically separated from the second FD node n_FD2. Accordingly, an output voltage corresponding to a voltage of the first FD node n_FD1 may be output through the first column line CL1. For example, illustrated in FIG. 7C, as the first and second LOFIC selection gates LoSS1 and LoSS2 and the first and second FD selection gates FDSG1 and FDSG2 are turned off, the first and second FD nodes n_FD1 and n_FD2 may be electrically separated. Accordingly, the high conversion gain (HCG) may be implemented. The conversion circuit 130 of the image sensor 100 may perform a sampling operation on the output voltage of the first column line CL1 to generate the reset value R-HCG1 of the first high conversion gain. For example, in association with the first pixel PIX1, the conversion circuit 130 of the image sensor 100 may sample the reset value R-HCG1 of the first high conversion gain based on the voltage of the first FD node n_FD1.

Afterwards, in a period from T3a to T4a, the image sensor 100 may perform a transfer operation on the first pixel PIX1. For example, in the period from T3a to T4a, the first transfer signal TS1 may be at the high level "H". As the first transfer gate TG1 is turned on in response to the first transfer signal TS1 of the high level "H", photoelectrons generated by the first photodiode PD1 may be transferred to the first FD node n_FD1, and the photoelectrons may be integrated at the first FD node n_FD1. In some example embodiments, as the photoelectrons are integrated at the first FD node n_FD1, the voltage of the first FD node n_FD1 may decrease. In some example embodiments, the period from T1a to T3a may correspond to an exposure time of the first pixel PIX1.

Afterwards, in a period from T4a to T5a, the image sensor 100 may sample a signal value S-HCG1 of the first high conversion gain in association with the first pixel PIX1. For example, in the period from T4a to T5a, the first transfer signal TS1 may be at the low level "L". The first transfer gate TG1 may be turned off in response to the first transfer signal TS1 of the low level "L", and the output voltage corresponding to the voltage of the first FD node n_FD1 may be output through the first column line CL1. The conversion circuit 130 of the image sensor 100 may perform a sampling operation on the output voltage to generate the signal value S-HCG1 of the first high conversion gain. That is, in association with the first pixel PIX1, the conversion circuit 130 of the image sensor 100 may sample the signal value S-HCG1 of the first high conversion gain based on the voltage of the first FD node n_FD1.

Afterwards, in a period from T5a to T6a, the image sensor 100 may sample a signal value S-LCG1 of the first low conversion gain in association with the first pixel PIX1. For example, in the period from T5a to T6a, the first FD selection signal FDSS1 may be at the high level "H". The first FD selection gate FDSG1 may be turned on in response to the first FD selection signal FDSS1 of the high level "H", and the first FD node n_FD1 may be electrically connected to the second FD node n_FD2. Accordingly, the output voltage corresponding to a sum voltage of the first and second FD nodes n_FD1 and n_FD2 (or a voltage of the shared FD node n_SFD) may be output through the first column line CL1. The conversion circuit 130 of the image sensor 100 may perform a sampling operation on the output voltage to generate the signal value S-LCG1 of the first low conversion gain.

In some example embodiments, in the period from T0 to T6a, pixels (e.g., Pixels PIX12 to PIX14 of the same row as the first pixel PIX1) may operate to be identical or similar to the first pixel PIX1.

After the sensing operation on the first pixel PIX1 is completed, the image sensor 100 may perform the sensing operation on the second pixel PIX2. In a period from T6a to T7a, the first selection signal SEL1 may be at the low level "L", the first reset signal RS1 may be at the high level "H", the second reset signal RS2 may be at the high level "H", and the second transfer signal TS2 may be at the high level "H". The first selection gate SG1 may be turned off in response to the first selection signal SEL1 of the low level "L", and the first and second reset gates RG1 and RG2 may be turned on in response to the first and second reset signals RS1 and RS2 of the high level "H". Because the first and second FD selection gates FDSG1 and FDSG2 are in a turn-on state and the second transfer gate TG2 is in a turn-on state, the first and second FD nodes n_FD1 and n_FD2 and the second photodiode PD2 may be reset with the pixel voltage VPIX or the level corresponding to the pixel voltage VPIX.

Afterwards, in a period from T7a to T8a, the image sensor 100 may sample a reset value R-LCG2 of a second low conversion gain in association with the second pixel PIX2. For example, in the period from T7a to T8a, the first reset signal RS1 may be at the low level "L", the second selection signal SEL2 may be at the high level "H", and the second reset signal RS2 may be at the low level "L". The first and second reset gates RS1 and RS2 may be turned off in response to the first and second reset signals RS1 and RS2 of the low level "L". The second selection gate SG2 may be turned on in response to the second selection signal SEL2 of the high level "H". In this case, because the first and second FD nodes n_FD1 and n_FD2 are in a state of being electrically connected, the output voltage corresponding to a voltage of the first and second FD nodes n_FD1 and n_FD2 may be output through the first column line CL1. The image sensor 100 may perform a sampling operation on the output voltage to generate the reset value R-LCG2 of the second low conversion gain. For example, in association with the second pixel PIX2, the image sensor 100 may sample a reset value corresponding to the shared FD node n_SFD as the reset value R-LCG2 of the second low conversion gain.

Afterwards, in a period from T8a to T9a, the image sensor 100 may sample a reset value R-HCG2 of a second high conversion gain in association with the second pixel PIX2. For example, in the period from T8a to T9a, the second FD selection signal FDSS2 may be at the low level "L". The second FD selection gate FDSG2 may be turned off in response to the second FD selection signal FDSS2 of the low level "L". Accordingly, because the second FD node n_FD2 is electrically separated from the first FD node n_FD1, the output voltage corresponding to a voltage of the second FD node n_FD2 may be output through the first column line CL1. The conversion circuit 130 of the image sensor 100 may perform a sampling operation on the output voltage to generate the reset value R-HCG2 of the second high conversion gain.

Afterwards, in a period from T9a to T10a, the image sensor 100 may perform the transfer operation on the second pixel PIX2. For example, in the period from T9a to T10a, the second transfer signal TS2 may be at the high level "H". As the second transfer gate TG2 is turned on in response to the second transfer signal TS2 of the high level "H", photoelectrons generated by the second photodiode PD2 may be transferred to the second FD node n_FD2, and the photoelectrons may be integrated at the second FD node n_FD2. In some example embodiments, as the photoelectrons are integrated at the second FD node n_FD2, the voltage of the second FD node n_FD2 may decrease. In some example embodiments, the period from T7a to T9a may correspond to an exposure time of the second pixel PIX2.

Afterwards, in a period from T10a to T11a, the image sensor 100 may sample a signal value S-HCG2 of the second high conversion gain in association with the second pixel PIX2. For example, in the period from T10a to T11a, the second transfer signal TS2 may be at the low level "L". The second transfer gate TG2 may be turned off in response to the second transfer signal TS2 of the low level "L", and the output voltage corresponding to the voltage of the second FD node n_FD2 may be output through the first column line CL1. The conversion circuit 130 of the image sensor 100 may perform a sampling operation on the output voltage to generate the signal value S-HCG2 of the second high conversion gain. For example, in association with the second pixel PIX2, the conversion circuit 130 of the image sensor 100 may sample the signal value S-HCG2 of the second high conversion gain based on the voltage of the second FD node n_FD2.

Afterwards, in a period from T11a to T12a, the image sensor 100 may sample a signal value S-LCG2 of the second low conversion gain in association with the second pixel PIX2. For example, in the period from T11a to T12a, the second FD selection signal FDSS2 may be at the high level "H". The second FD selection gate FDSG2 may be turned on in response to the second FD selection signal FDSS2 of the high level "H", and the second FD node n_FD2 may be electrically connected to the first FD node n_FD1. Accordingly, the output voltage corresponding to a sum voltage of the first and second FD nodes n_FD1 and n_FD2 (or a voltage of the shared FD node n_SFD) may be output through the first column line CL1. The conversion circuit 130 of the image sensor 100 may perform a sampling operation on the output voltage to generate the signal value S-LCG2 of the second low conversion gain. That is, in association with the second pixel PIX2, the conversion circuit 130 of the image sensor 100 may sample the signal value S-LCG2 of the second low conversion gain based on the voltage of the shared FD node n_SFD.

In some example embodiments, in the period from T7a to T12a, pixels (e.g., Pixels PIX22 to PIX24 of the same row as the second pixel PIX2) may operate to be identical or similar to the second pixel PIX2.

As described above, in the shared mode, the image sensor 100 may sample a reset value R-HCG of a high conversion gain and a signal value S-HCG of a high conversion gain based on the FD node included in each pixel and may sample a reset value R-LCG of a low conversion gain and a signal value S-LCG of a low conversion gain based on a sum of the FD node included in each pixel and the FD node of an adjacent pixel, that is, the shared FD node n_SFD. The digital logic circuit 150 of the image sensor 100 may combine the sampled values to generate the image data IMG to which the HDR is applied.

The sensing operation of the image sensor 100 in the shared mode, which is described with reference to FIGS. 7A to 7C, is provided as an example, and example embodiments are not limited thereto. For example, the image sensor 100 described with reference to FIGS. 7A to 7C may perform the sensing operation for each pixel, based on the RRSS method in which the values R-LCG, R-HCG, S-HCG, and S-LCG are sequentially sampled. However, the image sensor 100 may perform the sensing operation for each pixel, based on the RSSR method in which the values R-HCG, S-HCG, S-LCG, and R-LCG are sequentially sampled or various other readout methods.

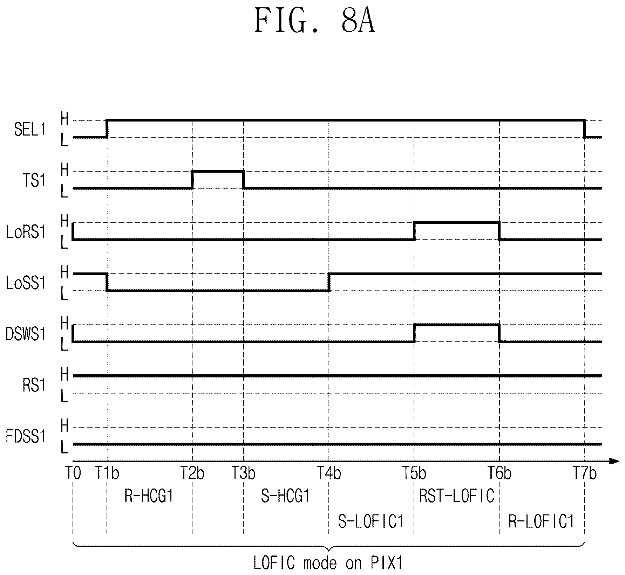

FIGS. 8A to 8C are diagrams for describing how an image sensor of FIG. 3 operates in an LOFIC mode. For convenience, the sensing operation for the first pixel PIX1 in the LOFIC mode will be described. However, example embodiments are not limited thereto, and the remaining pixels may operate to be similar to the first pixel PIX1. In some example embodiments, pixels (e.g., pixels PIX12 to PIX14) located at the same row as the first pixel PIX1 may operate at the same timing as the first pixel PIX1. Pixels (e.g., pixels PIX21 to PIX24) located at a row different from that of the first pixel PIX1 may operate at a timing different from that of the first pixel PIX1.

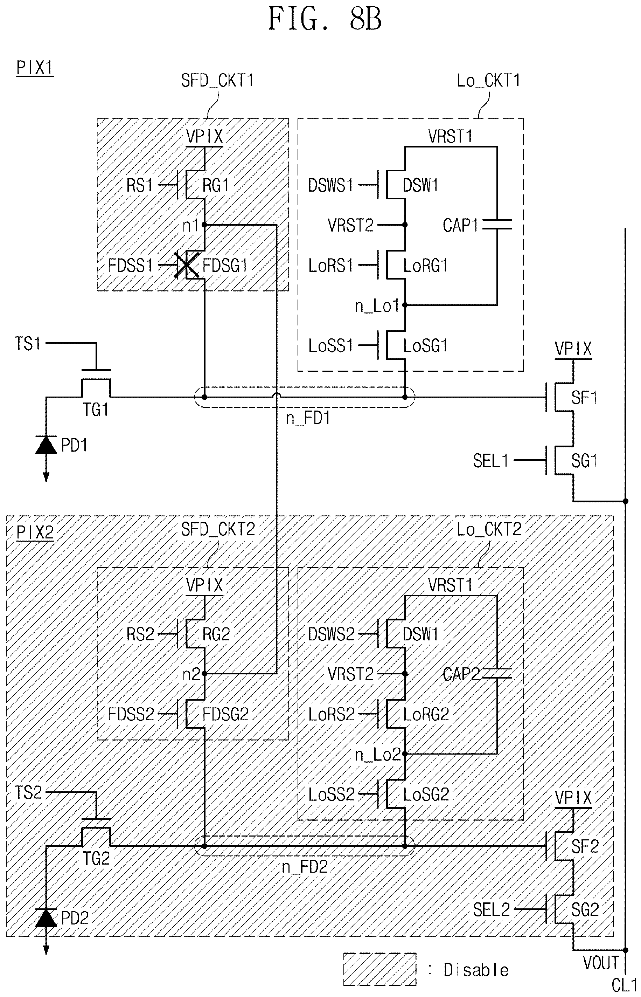

Referring to FIGS. 3, 5, 8A, 8B, and 8C, in a period from T0 to T7b, the first pixel PIX1 of the image sensor 100 may operate in the LOFIC mode. In this case, the first SFD circuit SFD_CKT1 of the first pixel PIX1 may be disabled. For example, in a period from T0 to T7b, the first FD selection signal FDSS1 may maintain the low level "L", and the first reset signal RS1 may maintain the high level "H". In this case, as illustrated in FIG. 8B, as the first FD selection gate FDSG1 is turned off in response to the first FD selection signal FDSS1 of the low level "L", the first FD node n_FD1 may be electrically separated from the second FD node n_FD2. For example, in the LOFIC mode, the first FD node n_FD1 may be electrically separated from the second FD node n_FD2. In some example embodiments, as illustrated in FIG. 8B, while the sensing operation for the first pixel PIX1 is performed in the LOFIC mode, the second pixel PIX2 may be disabled.

In the period from T0 to T1b, the first LOFIC selection gate LoSG1 of the first pixel PIX1 may be in a turn-on state. In this case, the first FD node n_FD1 and the first capacitor CAP1 are electrically connected. Photoelectrons flowing over the first photodiode PD1 may be integrated or stored at the first FD node n_FD1 and the first capacitor CAP1.

In the period from T1b to T2b, the image sensor 100 may sample the reset value R-HCG1 of the high conversion gain in association with the first pixel PIX1. For example, in the period from T1b to T2b, the first selection signal SEL1 may be at the high level "H", the first transfer signal TS1 may be at the low level "L", the first LOFIC reset signal LoRS1 may be at the low level "L", the first LOFIC selection signal LoSS1 may be at the low level "L", and the first discharge signal DSWS1 may be at the low level "L". The first selection gate SG1 may be turned on in response to the first selection signal SEL1 of the high level "H", the first transfer gate TG1 may be turned off in response to the first transfer signal TS1 of the low level "L", the first LOFIC reset gate LoRG1 may be turned off in response to the first LOFIC reset signal LoRS1ofthe low level "L", the first LOFIC selection gate LoSG1 may be turned off in response to the LOFIC selection signal LoSS1 of the low level "L", and the first discharge switch DSW1 may be turned off in response to the first discharge signal DSWS1 of the low level "L". In this case, the output voltage corresponding to a voltage of the first FD node n_FD1 may be output through the first column line CL1. The conversion circuit 130 of the image sensor 100 may perform a sampling operation on the output voltage to the reset value R-HCG1 of the first high conversion gain.

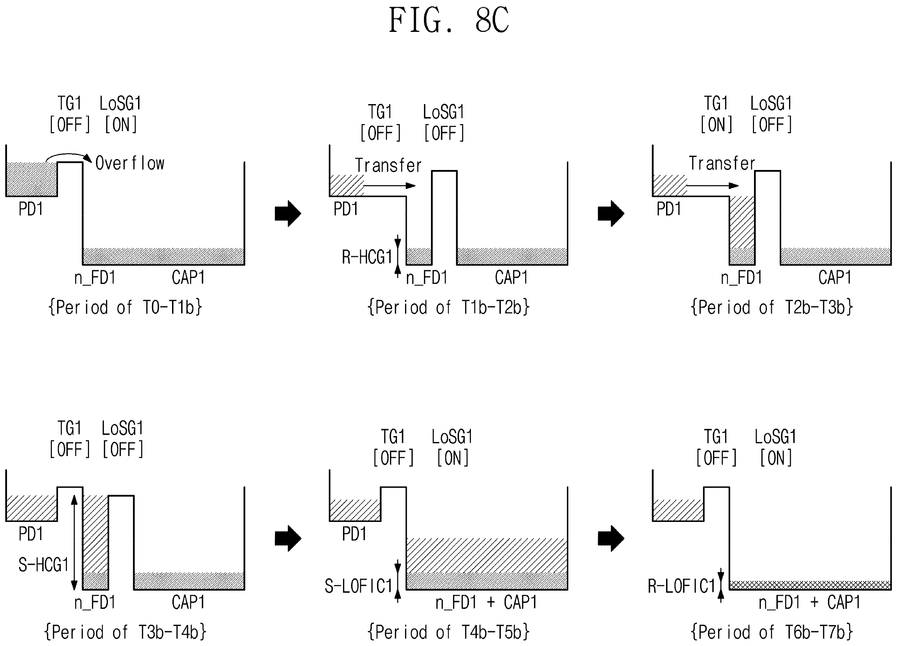

As an example, the external environment of the image sensor 100 may be a high-illuminance environment. In this case, as illustrated in the period from T1b to T2b of FIG. 8C, the photoelectrons generated by the first photodiode PD1 may overflow through the first transfer gate TG1 which is turned off, and the photoelectrons being full at the first FD node n_FD1 may overflow to the first capacitor CAP1 through the first LOFIC selection gate LoSG1 which is turned off. In this case, a value corresponding to the amount of photoelectrons integrated at the first FD node n_FD1 may be sampled as the reset value R-HCG1 of the first high conversion gain.

Afterwards, in the period from T2b to T3b, the image sensor 100 may perform the transfer operation on the first pixel PIX1. For example, in the period from T2b to T3b, the first transfer signal TS1 may be at the high level "H". The first transfer gate TG1 may be turned on in response to the first transfer signal TS1 of the high level "H". In this case, as illustrated in the period from T2b to T3b of FIG. 8C, as the first transfer gate TG1 is turned on, the photoelectrons of the first photodiode PD1 may move to the first FD node n_FD1.

Afterwards, in the period from T3b to T4b, the image sensor 100 may sample the signal value S-HCG1 of the first high conversion gain in association with the first pixel PIX1. For example, in the period from T3b to T4b, the first transfer signal TS1 may be at the low level "L". The first transfer gate TG1 may be turned off in response to the first transfer signal TS1 of the low level "L". In this case, as illustrated in the period from T3b to T4b of FIG. 8C, as the first transfer gate TG1 is turned off, the photoelectrons transferred from the first photodiode PD1 may be integrated at the first FD node n_FD1. The output voltage corresponding to a voltage of the first FD node n_FD1 may be output to the first column line CL1. The conversion circuit 130 of the image sensor 100 may perform a sampling operation on the output voltage to generate the signal value S-HCG1 of the first high conversion gain.

In the period from T4b to T5b, the image sensor 100 may sample a first LOFIC signal value S-LOFIC1 in association with the first pixel PIX1. For example, in the period from T4b to T5b, the first LOFIC selection signal LoSS1 may be at the high level "H". The first LOFIC selection gate LoSG1 may be turned on in response to the first LOFIC selection signal LoSS1 of the high level "H". As the first LOFIC selection gate LoSG1 is turned on, the first FD node n_FD1 and the first capacitor CAP1 may be electrically connected. In this case, as illustrated in the period from T4b to T5b, photoelectrons may be integrated at a sum (n_FD1 + CAP1) of the first FD node n_FD1 and the first capacitor CAP1. In some example embodiments, the photoelectrons integrated at the sum (n_FD1 + CAP1) of the first FD node n_FD1 and the first capacitor CAP1 may include photoelectrons overflowing from the first photodiode PD1 or the first FD node n_FD1. For example, the sum (n_FD1 + CAP1) of the first FD node n_FD1 and the first capacitor CAP1 may include image information lost at the first FD node n_FD1. The output voltage corresponding to a voltage of the sum (n_FD1 + CAP1) of the first FD node n_FD1 and the first capacitor CAP1 may be output through the first column line CL1. The conversion circuit 130 of the image sensor 100 may perform a sampling operation on the output voltage to generate the first LOFIC signal value S-LOFIC1.

In the period from T5b to T6b, the image sensor 100 may perform an LOFIC reset operation RST-LOFIC on the first pixel PIX1. For example, in the period from T5b to T6b, the first LOFIC reset signal LoRS1 and the first discharge signal DSWS1 may be at the high level "H". The first LOFIC reset gate LoRG1 may be turned on in response to the first LOFIC reset signal LoRS1 of the high level "H", and the first discharge switch DSW1 may be turned on in response to the first discharge signal DSWS1 of the high level "H". In this case, the first FD node n_FD1 and the first capacitor CAP1 may be reset by the first reset voltage VRST1 or the second reset voltage VRST2. For example, photoelectrons integrated at the first FD node n_FD1 and the first capacitor CAP1 may be discharged.

Afterwards, in the period from T6b to T7b, the image sensor 100 may sample a first LOFIC reset value R-LOFIC1 in association with the first pixel PIX1. For example, in the period from T6b to T7b, the first LOFIC reset signal LoRS1 and the first discharge signal DSWS1 may be at the low level "L". The first LOFIC reset gate LoRG1 may be turned off in response to the first LOFIC reset signal LoRS1 of the low level "L", and the first discharge switch DSW1 may be turned off in response to the first discharge signal DSWS1 of the low level "L". In this case, as illustrated in the period from T6b to T7b of FIG. 8C, the first FD node n_FD1 and the first capacitor CAP1 may be in a reset state. The output voltage corresponding to a voltage of the sum (n_FD1 + CAP1) of the first FD node n_FD1 and the first capacitor CAP1 may be output through the first column line CL1. The conversion circuit 130 of the image sensor 100 may perform a sampling operation on the output voltage to generate the first LOFIC reset value R-LOFIC1.

In some example embodiments, in the LOFIC mode, photoelectrons overflowing from the first photodiode PD1 or the first FD node n_FDI1 of the first pixel PIX1 may be stored or integrated at the first capacitor CAP1. Accordingly, in the high-illuminance environment, because photoelectrons exceeding a full well capacity (FWC) of the first photodiode PD1 or the first FD node n_FD1 are stored or integrated at the first capacitor CAP1, the loss of image information may be prevented.

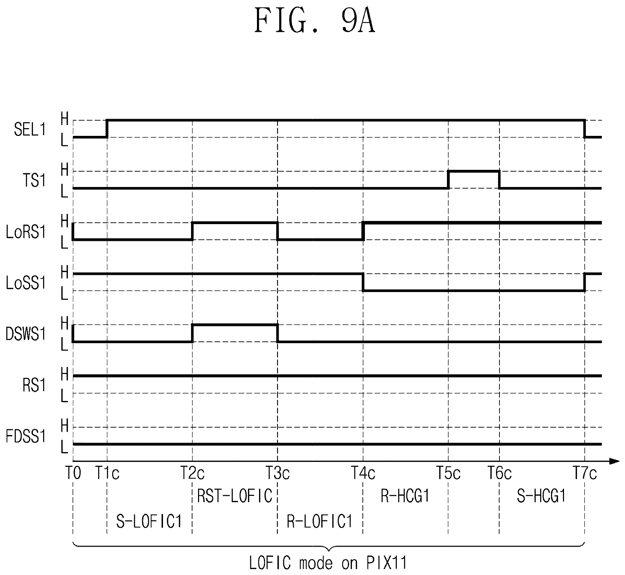

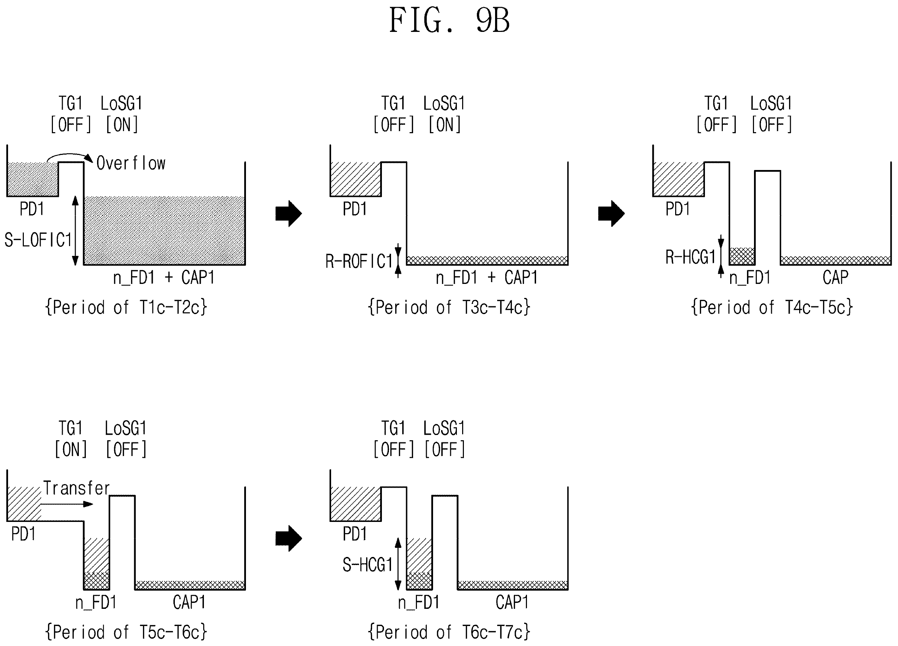

FIGS. 9A and 9B are diagrams for describing how an image sensor of FIG. 3 operates in an LOFIC mode. For convenience, the sensing operation for the first pixel PIX1 in the LOFIC mode will be described. However, example embodiments are not limited thereto, and the remaining pixels may operate to be similar to the first pixel PIX1.

Referring to FIGS. 3, 5, 9A, and 9B, the first pixel PIX1 of the image sensor 100 may operate in the LOFIC mode. In this case, the first SFD circuit SFD_CKT1 of the first pixel PIX1 may be disabled. For example, in a period from T0 to T7c, the first FD selection signal FDSS1 may maintain the low level "L", and the first reset signal RS1 may maintain the high level "H". This is described with reference to FIGS. 8A and 8B, and thus, additional description will be omitted to avoid redundancy.

In the period from T1c to T2c, the image sensor 100 may sample the first LOFIC signal value S-LOFIC1 in association with the first pixel PIX1. For example, in the period from T1c to T2c, the first selection signal SEL1 may be at the high level "H", the first transfer signal TS1 may be at the low level "L", the first LOFIC reset signal LoRS1 may be at the low level "L", the first LOFIC selection signal LoSS1 may be at the high level "H", and the first discharge signal DSWS1 may be at the low level "L". As the first LOFIC selection gate LoSG1 is turned on in response to the first LOFIC selection signal LoSS1 of the high level "H", the first FD node n_FD1 and the first capacitor CAP1 may be electrically connected. As an example, as illustrated in the period from T1c to T2c of FIG. 9B, the photoelectrons generated by the first photodiode PD1 may overflow. The photoelectrons overflowing from the first photodiode PD1 may be integrated or accumulated at a sum (n_FD1 + CAP1) of the first FD node n_FD1 and the first capacitor CAP1. The first selection gate SG1 may be turned on in response to the first selection signal SEL1 of the high level "H". According to the above description, the output voltage corresponding to a voltage of the sum (n_FD1 + CAP1) of the first FD node n_FD1 and the first capacitor CAP1 may be output through the first column line CL1. The conversion circuit 130 of the image sensor 100 may perform a sampling operation on the output voltage to generate the first LOFIC signal value S-LOFIC1.

In the period from T2c to T3c, the image sensor 100 may perform the LOFIC reset operation RST-LOFIC on the first pixel PIX1. For example, in the period from T2c to T3c, the first LOFIC reset signal LoRS1 and the first discharge signal DSWS1 may be at the high level "H". The first LOFIC reset gate LoRG1 may be turned on in response to the first LOFIC reset signal LoRS1 of the high level "H", and the first discharge switch DSW1 may be turned on in response to the first discharge signal DSWS1 of the high level "H". In this case, the first FD node n_FD1 and the first capacitor CAP1 may be reset by the first reset voltage VRST1 or the second reset voltage VRST2. For example, photoelectrons integrated at the first FD node n_FD1 and the first capacitor CAP1 may be discharged.

In the period from T3c to T4c, the image sensor 100 may sample the first LOFIC reset value R-LOFIC1 in association with the first pixel PIX1. For example, the first LOFIC reset signal LoRS1 and the first discharge signal DSWS1 may be at the low level "L". The first LOFIC reset gate LoRG1 may be turned off in response to the first LOFIC reset signal LoRS1 of the low level "L", and the first discharge switch DSW1 may be turned off in response to the first discharge signal DSWS1 of the low level "L". In this case, as illustrated in the period from T3c to T4c of FIG. 9B, the first FD node n_FD1 and the first capacitor CAP1 may be in a reset state. The output voltage corresponding to a voltage of the sum (n_FD1 + CAP1) of the first FD node n_FD1 and the first capacitor CAP1 may be output through the first column line CL1. The conversion circuit 130 of the image sensor 100 may perform a sampling operation on the output voltage to generate the first LOFIC reset value R-LOFIC1.

In the period from T4c to T5c, the image sensor 100 may sample the reset value R-HCG1 of the first high conversion gain in association with the first pixel PIX1. For example, in the period from T4c to T5c, the first LOFIC reset signal LoRS1 may be at the high level "H", and the first LOFIC selection signal LoSS1 may be at the low level "L". The first LOFIC reset gate LoRG1 may be turned on in response to the first LOFIC reset signal LoRS1 of the high level "H". The first LOFIC selection gate LoSG1 may be turned off in response to the first LOFIC selection signal LoSS1 of the low level "L". According to the above description, the first FD node n_FD1 and the first capacitor CAP1 may be electrically separated. As an example, as illustrated in the period from T4c to T5c of FIG. 9B, the first FD node n_FD1 may be in the reset state. The output voltage corresponding to a voltage of the first FD node n_FD1 may be output through the first column line CL1. The conversion circuit 130 of the image sensor 100 may perform a sampling operation on the output voltage to generate the reset value R-HCG1 of the first high conversion gain.

In the period from T5c to T6c, the image sensor 100 may perform the transfer operation on the first pixel PIX1. For example, in the period from T5c to T6c, the first transfer signal TS1 may be at the high level "H". The first transfer gate TG1 may be turned on in response to the first transfer signal TS1 of the high level "H". In this case, as illustrated in the period from T5c to T6c of FIG. 9B, as the first transfer gate TG1 is turned on, the photoelectrons of the first photodiode PD1 may move to the first FD node n_FD1.

In the period from T6c to T7c, the image sensor 100 may sample the signal value S-HCG1 of the first high conversion gain in association with the first pixel PIX1. For example, in the period from T6c to T7c, the first transfer signal TS1 may be at the low level "L". The first transfer gate TG1 may be turned off in response to the first transfer signal TS1 of the low level "L". In this case, as illustrated in the period from T6c to T7c, the first FD node n_FD1 may store and integrate the photoelectrons transferred from the first photodiode PD1 and may output the output voltage corresponding to the voltage of the first FD node n_FD1 through the first column line CL1. The conversion circuit 130 of the image sensor 100 may perform a sampling operation on the output voltage to generate the signal value S-HCG1 of the first high conversion gain.

As described above, the image sensor 100 may perform the sensing operation on a plurality of pixels based on various methods, in the LOFIC mode. For example, the sensing method described with reference to FIGS. 8A to 8C may be the RSSR method, and the sensing method described with reference to FIGS. 9A and 9B may be the SRRS method. However, example embodiments are not limited thereto.

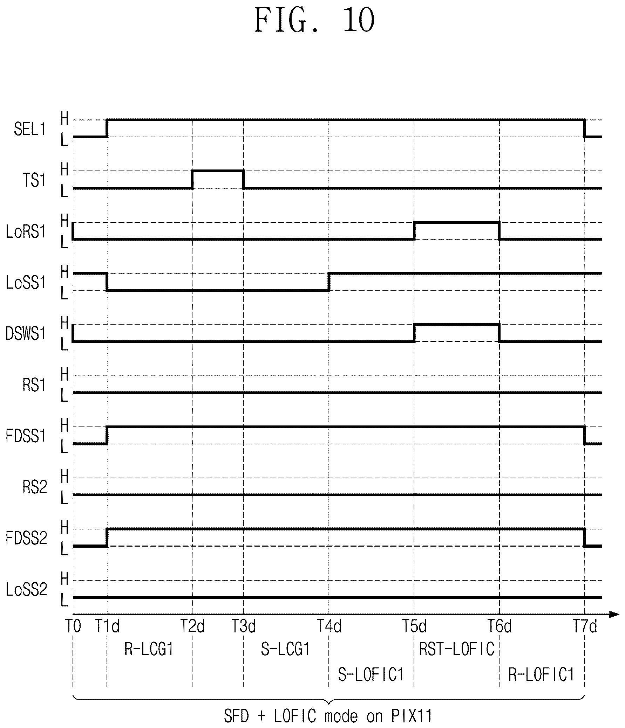

FIG. 10 is a timing diagram for describing an operation of an image sensor of FIG. 3. Referring to FIGS. 3, 5, and 10, the image sensor 100 may perform the sensing operation on the first pixel PIX1. In this case, the image sensor 100 may perform the sensing operation on each pixel by using the SFD circuit SFD_CKT and the LOFIC circuit Lo_CKT of each pixel.

In a period from T0 to T4d, the image sensor 100 may perform the sensing operation on the first pixel PIX1 by using the shared FD node n_SFD. For example, in the period from T1d to T2d, the image sensor 100 may sample the reset value R-LCG1 of the first low conversion gain in association with the first pixel PIX1.

In the period from T1d to T2d, the first selection signal SEL1 may be at the high level "H", the first transfer signal TS1 may be at the low level "L", the first LOFIC reset signal LoRS1 may be at the low level "L", the first LOFIC selection signal LoSS1 may be at the low level "L", the first discharge switch DSW1 may be at the low level "L", the first reset signal RS1 may be at the low level "L", the first FD selection signal FDSS1 may be at the high level "H", the second reset signal RS2 may be at the low level "L", the second FD selection signal FDSS2 may be at the high level "H", and the second LOFIC selection signal LoSS2 may be at the low level "L".

In this case, the first LOFIC selection gate LoSG1 may be turned off in response to the first LOFIC selection signal LoSS1 of the low level "L". Accordingly, the first FD node n_FD1 may be electrically separated from the first capacitor CAP1. The first and second FD selection gates FDSG1 and FDSG2 may be turned on in response to the first and second FD selection signals FDSS1 and FDSS2 of the high level "H". In this case, the first and second FD nodes n_FD1 and n_FD2 may be electrically connected and to form the shared FD node n_SFD. As the first selection gate SG1 is turned on in response to the first selection signal SEL1 of the high level "H", the output voltage corresponding to a voltage of the shared FD node n_SFD may be output through the first column line CL1. The image sensor 100 may perform a sampling operation on the output voltage to generate the reset value R-LCG1 of the first low conversion gain.

In the period from T2d to T3d, the image sensor 100 may perform the transfer operation on the first pixel PIX1. For example, in the period from T2d to T3d, the first transfer signal TS1 may be at the high level "H". As the first transfer gate TG1 is turned on in response to the first transfer signal TS1 of the high level "H", photoelectrons of the first photodiode PD1 may be transferred to the shared FD node n_SFD (e.g., a node at which the first and second FD nodes n_FD1 and n_FD2 are electrically connected).

In the period from T3d to T4d, the image sensor 100 may sample the signal value S-LCG1 of the first low conversion gain in association with the first pixel PIX1. For example, in the period from T3d to T4d, the first transfer signal TS1 may be at the low level "L". The first transfer gate TG1 may be turned off in response to the first transfer signal TS1 of the low level "L". In this case, the output voltage corresponding to a voltage of the shared FD node n_SFD may be output through the first column line CL1. The conversion circuit 130 of the image sensor 100 may perform a sampling operation on the output voltage to generate the signal value S-LCG1 of the first low conversion gain.

In the period from T4d to T7d, the image sensor 100 may perform the sensing operation on the first pixel PIX1 by using the LOFIC circuit. For example, in the period from T4d to T5d, the first LOFIC selection signal LoSS1 may be at the high level "H". The first LOFIC selection gate LoSG1 may be turned on in response to the first LOFIC selection signal LoSS1 of the high level "H". In this case, the shared FD node n_SFD may be electrically connected to the first capacitor CAP1. For example, as the first FD node n_FD1, the second FD node n_FD2, and the first capacitor CAP1 are electrically connected, the pixel capacitance may increase. The output voltage corresponding to a voltage of the sum of the shared FD node n_SFD and the first capacitor CAP1 may be output through the first column line CL1. The conversion circuit 130 of the image sensor 100 may sample the first LOFIC signal value S-LOFIC1 based on the output voltage.

In the period from T5d to T6d, the image sensor 100 may perform the LOFIC reset operation RST-LOFIC on the first pixel PIX1. For example, in the period from T5d to T6d, the first LOFIC reset signal LoRS1 may be at the high level "H", and the first discharge signal DSWS1 may be at the high level "H". The first LOFIC reset gate LoRG1 may be turned on in response to the first LOFIC reset signal LoRS1 of the high level "H", and the first discharge switch DSW1 may be turned on in response to the first discharge signal DSWS1 of the high level "H". According to the above description, the shared FD node n_SFD (or the first and second FD nodes n_FD1 and n_FD2) and the first capacitor CAP1 may be reset by the first reset voltage VRST1 or the second reset voltage VRST2. That is, the photoelectrons integrated at the first FD node n_FD1, the second FD node n_FD2, and the first capacitor CAP1 may be discharged.

In the period from T6d to T7d, the image sensor 100 may sample the first LOFIC reset value R-LOFIC1 in association with the first pixel PIX1. For example, in the period from T6d to T7d, the first LOFIC reset signal LoRS1 may be at the low level "L", and the first discharge signal DSWS1 may be at the low level "L". The first LOFIC reset gate LoRG1 may be turned off in response to the first LOFIC reset signal LoRS1 of the low level "L", and the first discharge switch DSW1 may be turned off in response to the first discharge signal DSWS1 of the low level "L". The shared FD node n_SFD (or the first and second FD nodes n_FD1 and n_FD2) and the first capacitor CAP1 may be in the reset state, and the output voltage corresponding to a voltage of the shared FD node n_SFD (or the first and second FD nodes n_FD1 and n_FD2) and the first capacitor CAP1 may output through the first column line CL1. The image sensor 100 may sample the first LOFIC reset value R-LOFIC1 based on the output voltage.

In some example embodiments, when the image sensor 100 performs the sensing operation on each pixel by using the shared FD node n_SFD, the pixel capacitance of each pixel may have a first value; when the image sensor 100 performs the sensing operation on each pixel by using the capacitor of the LOFIC circuit Lo_CKT, the pixel capacitance of each pixel may have a second value greater than the first value; when the image sensor 100 performs the sensing operation on each pixel by using the shared FD node n_SFD and the capacitor of the LOFIC circuit Lo_CKT, the pixel capacitance of each pixel may have a third value greater than the second value. That is, the image sensor 100 may variously control or vary the pixel capacitance (or conversion gain) for each pixel through various modes. In some example embodiments, as the pixel capacitance (or conversion gain) for each pixel is variously controlled or varied, the bit depth for HDR implementation may be variously varied.

In some example embodiments, the description is given as each of the plurality of pixels operates in the shared mode or the LOFIC mode, but example embodiments are not limited thereto. For example, under a specific condition, the SFD circuit and the LOFIC circuit of each of the plurality of pixels may be disabled. In this case, each of the plurality of pixels may perform the sensing operation by using the FD node included therein. For example, as the SFD circuit and the LOFIC circuit of each of the plurality of pixels are disabled, the pixel capacitance of each of the plurality of pixels may decrease, or the conversion gain may increase, and thus, in an ultra-low-illuminance environment, improved image data may be generated.

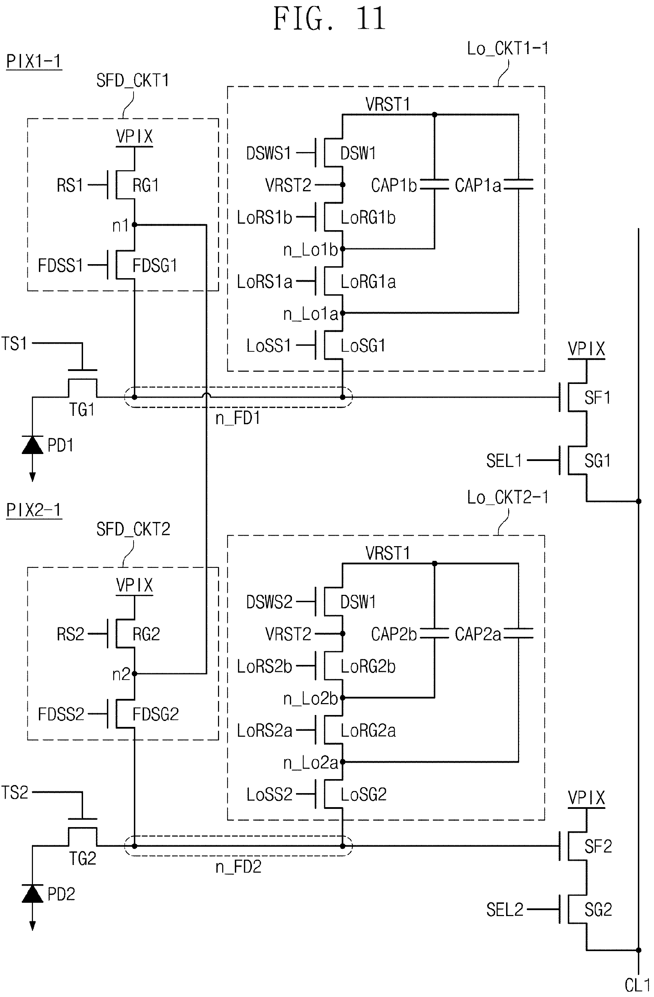

FIG. 11 is a circuit diagram illustrating some pixels of a pixel array of FIG. 4 in detail. Referring to FIGS. 4 and 11, the pixel array 110 may include a first pixel PIX1-1 and a second pixel PIX2-1. The first and second pixels PIX1-1 and PIX2-1 may respectively correspond to the 11-th and 21-th pixels PIX11 and PIX21 of FIG. 4. In some example embodiments, the first and second pixels PIX1-1 and PIX2-1 may be similar in structures to the 11-th and 21-th pixels PIX1 and PIX2 of FIG. 5. Below, for convenience, a difference between the first and second pixels PIX1-1 and PIX2-1 and the 11-th and 21-th pixels PIX1 and PIX2 will be mainly described.

A first LOFIC circuit Lo_CKT1-1 of the first pixel PIX1-1 of FIG. 11 may further include an additional capacitor compared to the first LOFIC circuit Lo_CKT1 of the first pixel PIX1 of FIG. 4 and may vary or control the pixel capacitance (or conversion gain) of the first pixel PIX1-1 more widely by using the additional capacitor. For example, the first LOFIC circuit Lo_CKT1-1 of the first pixel PIX1-1 may include the first LOFIC selection gate LoSG1, a 1a-th LOFIC reset gate LoRG1a, a 1b-th LOFIC reset gate LoRG1b, the first discharge switch DSW1, a 1a-th capacitor CAP1a, and a 1b-th capacitor CAP1b.

The first LOFIC selection gate LoSG1 may be connected between the first FD node n_FD1 and a 1a-th LOFIC node n_Lola and may operate in response to the first LOFIC selection signal LoSS1. The 1a-th LOFIC reset gate LoRGla may be connected between the 1a-th LOFIC node n_Lo1a and a 1b-th LOFIC node n_Lolb and may operate in response to a 1a-th LOFIC reset signal LoRS1a. The 1b-th LOFIC reset gate LoRG1b may be connected between the 1b-th LOFIC node n_Lolb and the second reset voltage VRST2 and may operate in response to a 1b-th LOFIC reset signal LoRS1b. The first discharge switch DSW1 may be connected between the first reset voltage VRST1 and the second reset voltage VRST2 and may operate in response to the first discharge signal DSWS1. The la-th capacitor CAP1a may be connected between the 1a-th LOFIC node n_Lola and the first reset voltage VRST1. The 1b-th capacitor CAP1b may be connected between the 1b-th LOFIC node n_Lolb and the first reset voltage VRST1.

A second LOFIC circuit Lo_CKT2-1 of the second pixel PIX2-1 may include the second LOFIC selection gate LoSG2, a 2a-th LOFIC reset gate LoRG2a, a 2b-th LOFIC reset gate LoRG2b, the second discharge switch DSW2, a 2a-th capacitor CAP2a, and a 2b-th capacitor CAP2b. In some example embodiments, a structure and an operation of the second LOFIC circuit Lo_CKT2-1 of the second pixel PIX2-1 are similar to those of the first LOFIC circuit Lo_CKT1-1 of the first pixel PIX1-1, and thus, additional description will be omitted to avoid redundancy.

In some example embodiments, the first and second pixels PIX1-1 and PIX2-1 may be configured to perform the sensing operation based on the shared mode or the LOFIC mode described above.

In some example embodiments, in the LOFIC mode, the image sensor 100 may selectively electrically connect the 1a-th capacitor CAP1a or the 1b-th capacitor CAP1b with the first FD node n_FD1 during the sensing operation of the first pixel PIX1-1. For example, in the LOFIC mode, the image sensor 100 may electrically connect the first FD node n_FD1 of the first pixel PIX1-1 with the 1a-th capacitor CAP1a by turning on the first LOFIC selection gate LoSG1 and turning off the 1a-th and the 1b-th LOFIC reset gates LoRG1a and LoRG1b. Alternatively, in the LOFIC mode, the image sensor 100 may electrically connect the first FD node n_FD1 of the first pixel PIX1-1 with the 1a-th capacitor CAP1a and the 1b-th capacitor CAP1b by turning on the first LOFIC selection gate LoSG1 and the 1a-th LOFIC reset gate LoRGla and turning off the 1b-th LOFIC reset gate LoRG1b. In this case, the pixel capacitance or the conversion gain of the first pixel PIX1-1 may be variously controlled depending on a capacitor connected to the first FD node n_FD1.

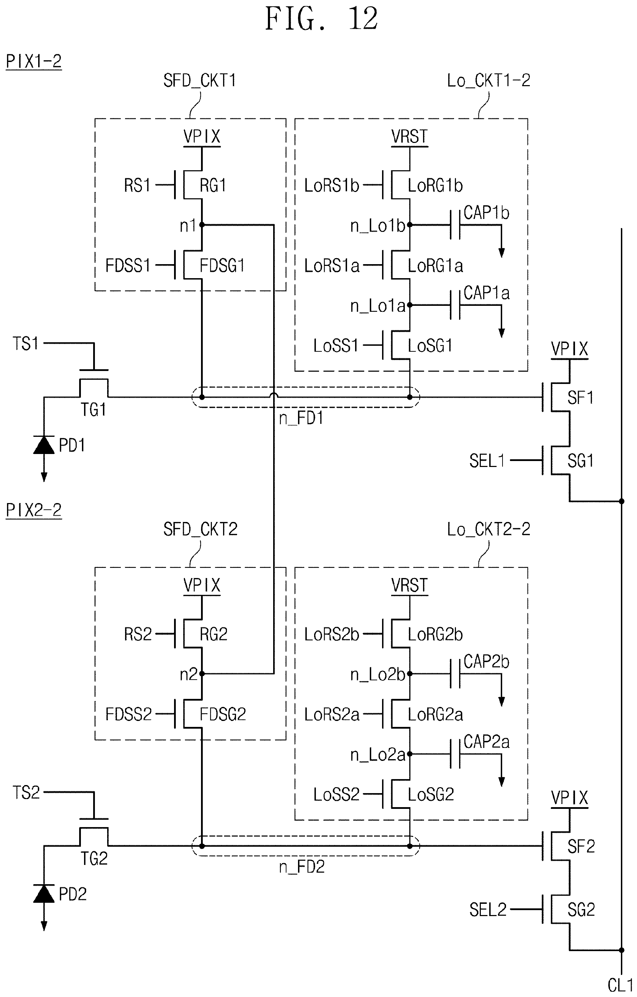

FIG. 12 is a circuit diagram illustrating some pixels of a pixel array of FIG. 4. Referring to FIGS. 4 and 12, the pixel array 110 may include a first pixel PIX1-2 and a second pixel PIX2-2. For convenience, the detailed description associated with the components described with reference to FIG. 5 from among components of the first and second pixels PIX1-2 and PIX2-2 is omitted.

Referring to FIGS. 4 and 12, a first LOFIC circuit Lo_CKT1-2 of the first pixel PIX1-2 may include the first LOFIC selection gate LoSG1, the 1a-th LOFIC reset gate LoRG1a, the 1b-th LOFIC reset gate LoRG1b, the 1a-th capacitor CAP1a, and the 1b-th capacitor CAP1b. The first LOFIC selection gate LoSG1 may be connected between the first FD node n_FD1 and the 1a-th LOFIC node n_Lola and may operate in response to the first LOFIC selection signal LoSS1. The 1a-th LOFIC reset gate LoRG1a may be connected between the 1a-th LOFIC node n_Lola and the 1b-th LOFIC node n_Lolb and may operate in response to the 1a-th LOFIC reset signal LoRS1a. The 1b-th LOFIC reset gate LoRG1b may be connected between the 1b-th LOFIC node n_Lo1b and the reset voltage VRST and may operate in response to the 1b-th LOFIC reset signal LoRS1b.

A second LOFIC circuit Lo_CKT2-2 of the second pixel PIX2-2 may include the second LOFIC selection gate LoSG2, a 2a-th LOFIC reset gate LoRS2a, a 2b-th LOFIC reset gate LoRG2b, a 2a-th capacitor CAP2a, and a 2b-th capacitor CAP2b. The second LOFIC circuit Lo_CKT2-2 of the second pixel PIX2-2 is similar in structure to the first LOFIC circuit Lo_CKT1-2 of the first pixel PIX1-2, and thus, additional description will be omitted to avoid redundancy.

In some example embodiments, in the LOFIC mode, the image sensor 100 may selectively connect the 1a-th capacitor CAP1a or the 1b-th capacitor CAP1b with the first FD node n_FD1 in association with the first pixel PIX1-2. For example, in the LOFIC mode, the image sensor 100 may electrically connect the first FD node n_FD1 and the 1a-th capacitor CAP1a by turning on the first LOFIC selection gate LoSG1 and turning off the 1a-th and the 1b-th LOFIC reset gates LoRGla and LoRG1b. Alternatively, in the LOFIC mode, in association with the first pixel PIX1-2, the image sensor 100 may electrically connect the first FD node n_FD1, the 1a-th capacitor CAP1a, and the 1b-th capacitor CAP1b by turning on the first LOFIC selection gate LoSG1 and the 1a-th LOFIC reset gate LoRG1a and turning off the 1b-th LOFIC reset gate LoRG1b.

In this case, the capacitance or the conversion gain of the first pixel PIX1-2 may be variously controlled depending on a capacitor connected to the first FD node n_FD1.

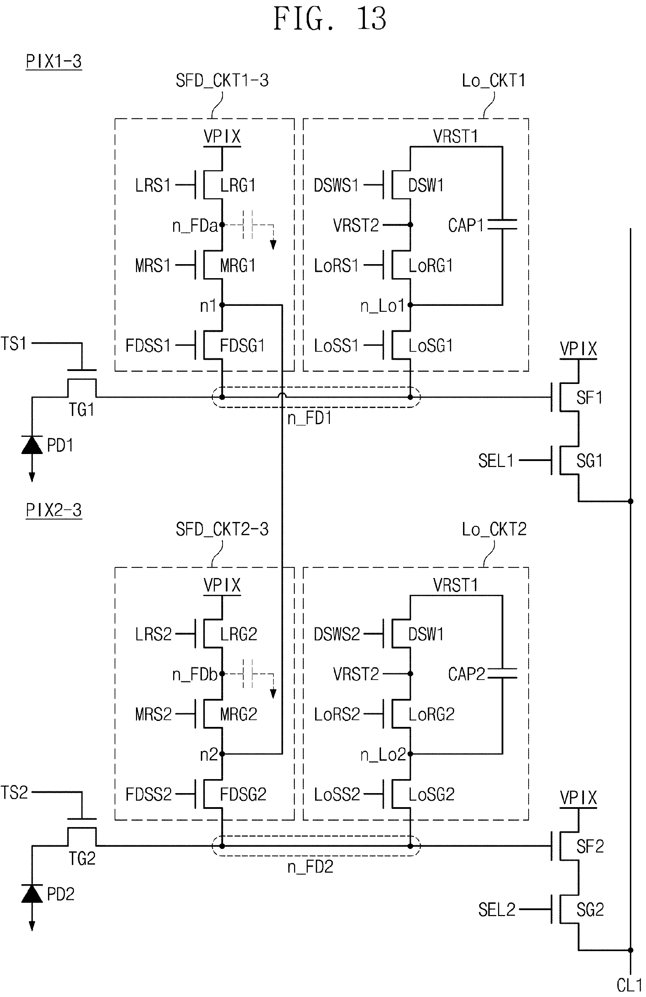

FIG. 13 is a circuit diagram illustrating some pixels of a pixel array of FIG. 4 in detail. Referring to FIGS. 4 and 13, the pixel array 110 may include a first pixel PIX1-3 and a second pixel PIX2-3. For convenience, the detailed description associated with the components described with reference to FIG. 5 from among components of the first and second pixels PIX1-3 and PIX2-3 is omitted.

A first SFD circuit SFD_CKT1-3 of the first pixel PIX1-3 may include the first FD selection gate FDSG1, a first middle reset gate MRG1, and a first low reset gate LRG1. The first FD selection gate FDSG1 may be connected between the first FD node n_FD1 and the first node n1 and may operate in response to the first FD selection signal FDSS1. The first middle reset gate MRG1 may be connected between the first node n1 and an a-th FD node n_FDa and may operate in response to a first middle reset signal MRS1. The first low reset gate LRG1 may be connected between the a-th FD node n_FDa and the pixel voltage VPIX and may operate in response to a first low reset signal LRS1.

A second SFD circuit SFD_CKT2-3 of the second pixel PIX2-3 may include the second FD selection gate FDSG2, a second middle reset gate MRG2, and a second low reset gate LRG2. The second SFD circuit SFD_CKT2-3 of the second pixel PIX2-3 is similar in structure to the first SFD circuit SFD_CKT1-3 of the first pixel PIX1-3, and thus, additional description will be omitted to avoid redundancy.

In some example embodiments, in the shared mode, in association with the first pixel PIX1-3, the image sensor 100 may selectively connect the first FD node n_FD1, the second FD node n_FD2, the a-th FD node n_FDa, and a b-th FD node n_FDb. For example, as the first and second FD selection gates FDSG1 and FDSG2 are turned on, the first and second middle reset gates MRG1 and MRG2 are turned off, and the first and second low reset gates LRG1 and LRG2 are turned off, the first and second FD nodes n_FD1 and n_FD2 may be electrically connected. In this case, the shared FD node n_SFD may correspond to the first and second FD nodes n_FD1 and n_FD2.

Alternatively, as the first and second FD selection gates FDSG1 and FDSG2 are turned on, the first middle reset gate MRG1 is turned on, the second middle reset gate MRG2 is turned off, and the first and second low reset gates LRG1 and LRG2 are turned off, the a-th, first, and second FD nodes n_FDa, n_FD1, and n_FD2 may be electrically connected. In this case, the shared FD node n_SFD may correspond to the a-th, first, and second FD nodes n_FDa, n_FD1, and n_FD2.

As described above, the image sensor 100 may vary the pixel capacitance or the conversion gain by selectively connecting the FD node of each pixel or the FD node of an adjacent pixel.

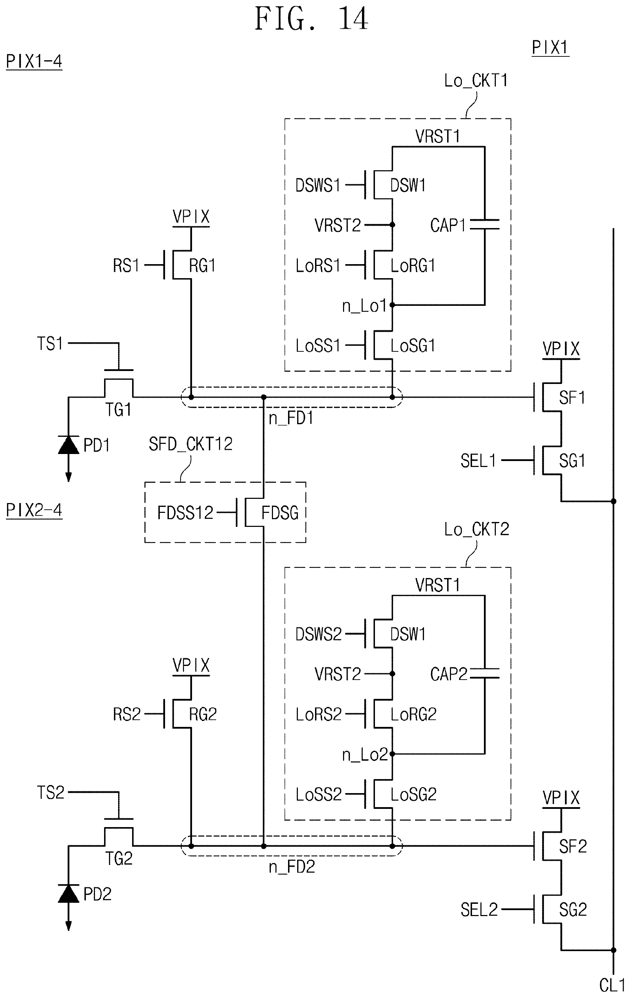

FIG. 14 is a circuit diagram illustrating some pixels of a pixel array of FIG. 4. Referring to FIGS. 4 and 14, the pixel array 110 may include a first pixel PIX1-4 and a second pixel PIX2-4. For convenience, the detailed description associated with the components described with reference to FIG. 5 from among components of the first and second pixels PIX1-4 and PIX2-4 is omitted.

In the first pixel PIX1-4, the first reset gate RG1 may be connected between the first FD node n_FD1 and the pixel voltage VPIX and may operate in response to the first reset signal RS1. In the second pixel PIX2-4, the second reset gate RG2 may be connected between the second FD node n_FD2 and the pixel voltage VPIX and may operate in response to the second reset signal RS2.

A 12-th SFD circuit SFD_CKT12 may be located between the first FD node n_FD1 of the first pixel PIX1-4 and the second FD node n_FD2 of the second pixel PIX2-4. The 12-th SFD circuit SFD_CKT12 may include a 12-th FD selection gate FDSG12 which is connected between the first FD node n_FD1 and the second FD node n_FD2 and is configured to operate in response to a 12-th FD selection signal FDSS12.

In some example embodiments, when the first pixel PIX1-4 or the second pixel PIX2-4 operates in the shared mode, the 12-th FD selection gate FDSG12 may be turned on such that the first and second FD nodes n_FD1 and n_FD2 are electrically connected.

Various embodiments of the SFD circuit SFD_CKT and the LOFIC circuit Lo_CKT included in each pixel are described with reference to FIGS. 11 to 14, but example embodiments are not limited thereto. Various embodiments of the SFD circuit SFD_CKT and the LOFIC circuit Lo_CKT included in each pixel, which are described with reference to FIGS. 11 to 14, may be individually implemented, or at least some components may be combined and implemented. For example, a first pixel may be configured to include the LOFIC circuit Lo_CKT1-1 of FIG. 11 and the SFD circuit SFD_CKT1-3 of FIG. 13. However, example embodiments are not limited thereto. For example, it may be understood that various other combinations are possible.

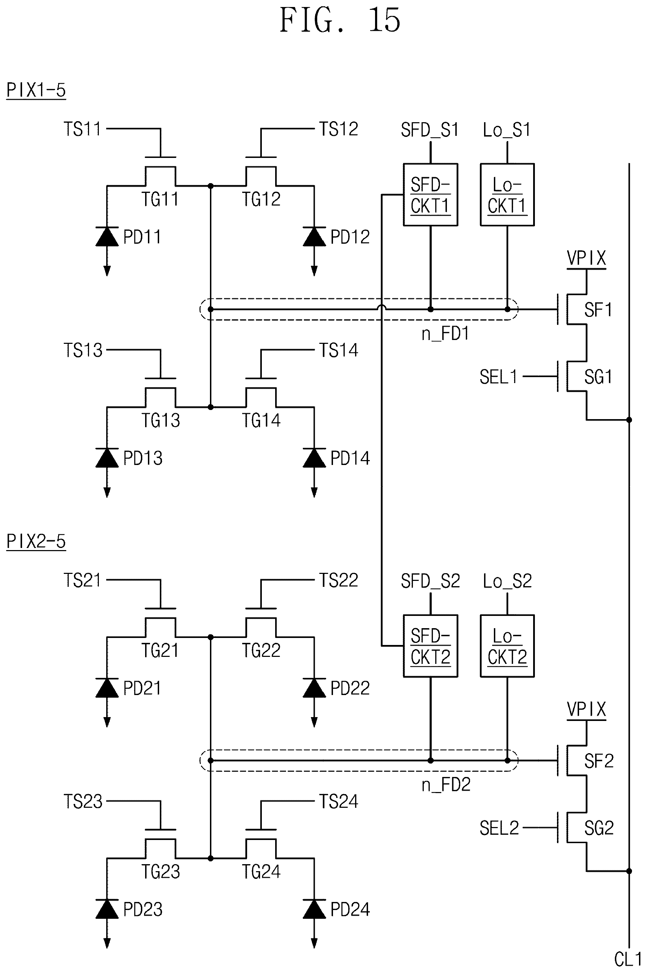

FIG. 15 is a diagram illustrating some pixels included in a pixel array of FIG. 2. Referring to FIGS. 2 and 15, the pixel array 110 may include a first pixel PIX1-5 and a second pixel PIX2-5. The first pixel PIX1-5 may include a plurality of photodiodes PD11 to PD14, a plurality of transfer gates TG11 to TG14, the first SFD circuit SFD_CKT1, the first LOFIC circuit Lo_CKT1, the first source follower SF1, and the first selection gate SG1. The first SFD circuit SFD_CKT1 may operate in response to the first SFD control signal SFD_S1. The first LOFIC circuit Lo_CKT1 may operate in response to the first LOFIC control signal Lo_S1. The second pixel PIX2-5 may include a plurality of photodiodes PD21 to PD24, a plurality of transfer gates TG21 to TG24, the second SFD circuit SFD_CKT2, the second LOFIC circuit Lo_CKT2, the second source follower SF2, and the second selection gate SG2. The second SFD circuit SFD_CKT2 may operate in response to the second SFD control signal SFD_S2. The second LOFIC circuit Lo_CKT2 may operate in response to the second LOFIC control signal Lo_S2.

The first SFD circuit SFD_CKT1, the first LOFIC circuit Lo_CKT1, the first source follower SF1, and the first selection gate SG1 of the first pixel PIX1-5 and the second SFD circuit SFD_CKT2, the second LOFIC circuit Lo_CKT2, the second source follower SF2, and the second selection gate SG2 of the second pixel PIX2-5 are similar those described above, and thus, additional description will be omitted to avoid redundancy.

In the first pixel PIX1-5, the plurality of photodiodes PD11 to PD14 may share the first FD node n_FD1. In the second pixel PIX2-5, the plurality of photodiodes PD21 to PD24 may share the second FD node n_FD2.

For example, the 11-th transfer gate TG11 may be connected between the 11-th photodiode PD11 and the first FD node n_FD1 and may operate in response to a 11-th transfer signal TS11. The 12-th transfer gate TG12 may be connected between the 12-th photodiode PD12 and the first FD node n_FD1 and may operate in response to a 12-th transfer signal TS12. The 13-th transfer gate TG13 may be connected between the 13-th photodiode PD13 and the first FD node n_FD1 and may operate in response to a 13-th transfer signal TS13. The 14-th transfer gate TG14 may be connected between the 14-th photodiode PD14 and the first FD node n_FD1 and may operate in response to a 14-th transfer signal TS14. The 21-th transfer gate TG21 may be connected between the 21-th photodiode PD21 and the second FD node n_FD2 and may operate in response to a 21-th transfer signal TS21. The 22-th transfer gate TG22 may be connected between the 22-th photodiode PD22 and the second FD node n_FD2 and may operate in response to a 22-th transfer signal TS22. The 23-th transfer gate TG23 may be connected between the 23-th photodiode PD23 and the second FD node n_FD2 and may operate in response to a 23-th transfer signal TS23. The 24-th transfer gate TG24 may be connected between the 24-th photodiode PD24 and the second FD node n_FD2 and may operate in response to a 24-th transfer signal TS24.

In some example embodiments, in the shared mode, the image sensor 100 may electrically connect the first and second FD nodes n_FD1 and n_FD2 during the sensing operation of the first pixel PIX1-5. For example, during the sensing operation of the first pixel PIX1-5, the first and second FD nodes n_FD1 and n_FD2 may be electrically connected through the first SFD circuit SFD_CKT1 and the second SFD circuit SFD_CKT2. The image sensor 100 may turn on the 11-th transfer gate TG11 such that photoelectrons are transferred from the 11-th photodiode PD11 to the first and second FD nodes n_FD1 and n_FD2. Afterwards, the image sensor 100 may reset the first and second FD nodes n_FD1 and n_FD2 and may turn on the 12-th transfer gate TG12 such that photoelectrons are transferred from the 12-th photodiode PD12 to the first and second FD nodes n_FD1 and n_FD2. As in the above description, each of the 13-th and 14-th photodiodes PD13 and PD14 may perform the sensing operation.

As described above, each pixel of the image sensor 100 may include a plurality of photodiodes. A structure and an operation of a plurality of photodiodes included in one pixel may be similar to those described above except that the plurality of photodiodes share an FD node included in one pixel.

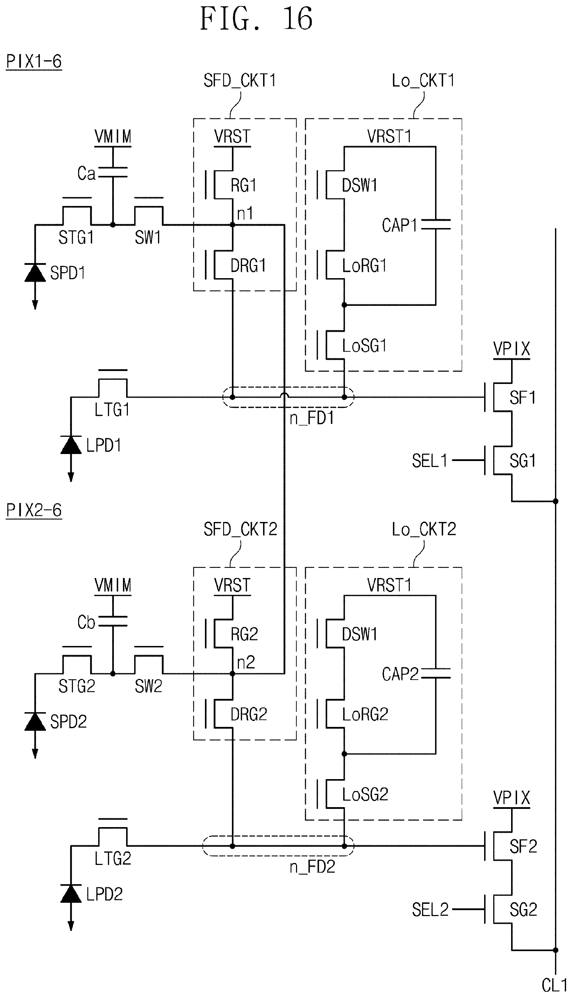

FIG. 16 is a diagram illustrating some pixels included in a pixel array of FIG. 2. Below, for brevity of drawing and for convenience of description, a separate control signal or a separate signal line for controlling each gate or transistor will be omitted in FIG. 16. However, example embodiments are not limited thereto. For example, it may be understood that each gate or each transistor is turned on or turned off by a corresponding control signal.

Referring to FIGS. 2 and 16, the pixel array 110 may include a first pixel PIX1-6 and a second pixel PIX2-6. The first and second pixels PIX1-6 and PIX2-6 may include the SFD circuits SFD_CKT1 and SFD_CKT2 and the LOFIC circuits Lo_CKT1 and Lo_CKT2 described above. That is, as in the above description, each of the first and second pixels PIX1-6 and PIX2-6 may operate in the shared mode or the LOFIC mode.

In some example embodiments, each of the first and second pixels PIX1-6 and PIX2-6 may be a split photodiode structure. For example, the first pixel PIX1-6 may include a first large photodiode LPD1, a first large transfer gate LTG1, a first gain control gate DRG1, the first reset gate RG1, a first switch SW1, a first small photodiode SPD1, a first small transfer gate STG1, an a-th capacitor Ca, the first LOFIC selection gate LoSG1, the first LOFIC reset gate LoRG1, the first discharge switch DSW1, the first capacitor CAP1, the first source follower SF1, and the first selection gate SG1.

The first large transfer gate LTG1 may be connected between the first large photodiode LPD1 and the first FD node n_FD1. The first gain control gate DRG1 may be connected between the first node n1 and the first FD node n_FD1. The first reset gate RG1 may be connected between the first node n1 and the reset voltage VRST. The first small transfer gate STG1 and the first switch SW1 may be connected between the first node n1 and the first small photodiode SPD1 in series. The a-th capacitor Ca may be connected between a node between the first small transfer gate STG1 and the first switch SW1 and a capacitor voltage VMIM. The first source follower SF1 may be configured to transfer the pixel voltage VPIX in response to a voltage of the first FD node n_FD1. The first selection gate SG1 may be connected between the first source follower SF1 and the first column line CL1.

The first LOFIC selection gate LoSG1, the first LOFIC reset gate LoRG1, the first discharge switch DSW1, and the first capacitor CAP1 may be included in the first LOFIC circuit Lo_CKT1. A structure of the first LOFIC circuit Lo_CKT1 is similar to that described above, and thus, additional description will be omitted to avoid redundancy.

The second pixel PIX2-6 may include a second large photodiode LPD2, a second large transfer gate LTG2, a second gain control gate DRG2, the second reset gate RG2, a second switch SW2, a second small photodiode SPD2, a second small transfer gate STG2, a b-th capacitor Cb, the second LOFIC selection gate LoSG2, the second LOFIC reset gate LoRG2, the second discharge switch DSW2, the second capacitor CAP2, the second source follower SF2, and the second selection gate SG2. A structure of the second pixel PIX2-6 is similar to the structure of the first pixel PIX1-6, and thus, additional description will be omitted to avoid redundancy.

In some example embodiments, depending on the operation mode (e.g., the shared mode or the LOFIC mode), the image sensor 100 may electrically connect the first and second FD nodes n_FD1 and n_FD2 respectively included in the pixels PIX1-6 and PIX2-6 or may connect the first and second FD nodes n_FD1 and n_FD2 to the first and second capacitors CAP1 and CAP2, respectively. For example, in the shared mode, in association with the first pixel PIX1-6, the image sensor 100 may electrically connect the first and second FD nodes n_FD1 and n_FD2 by turning on the first and second gain control gates DRG1 and DRG2. Alternatively or additionally, in the LOFIC mode, in association with the first pixel PIX1-6, the image sensor 100 may electrically connect the first FD node n_FD1 and the first capacitor CAP1 by turning on the first LOFIC selection gate LoSG1. Accordingly, the pixel capacitance or the conversion gain of each pixel may be variously varied or controlled.

In some example embodiments, the split photodiode structure described with reference to FIG. 16 may be applied to an image sensor for an autonomous driving system.

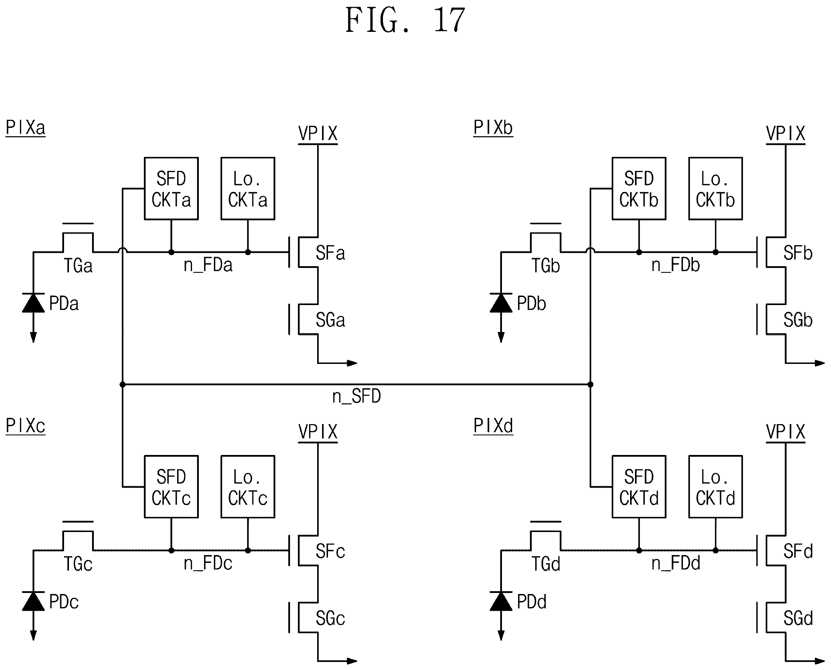

FIG. 17 is a diagram illustrating some pixels of a pixel array of FIG. 2. For convenience of description, additional description associated with the components described above will be omitted to avoid redundancy. Referring to FIGS. 2 and 17, a pixel array 100 may include a plurality of pixels PIXa to PIXd.

The a-th pixel PIXa may include an a-th photodiode PDa, an a-th transfer gate TGa, an a-th SFD circuit SFD_CKTa, an a-th LOFIC circuit Lo_CKTa, an a-th source follower SFa, and an a-th selection gate SGa. The a-th transfer gate TGa may be connected between the a-th photodiode PDa and an a-th FD node n_FDa. The a-th SFD circuit SFD_CKTa and the a-th LOFIC circuit Lo_CKTa may be connected to the a-th FD node n_FDa. The a-th source follower SFa may operate in response to a voltage of the a-th FD node n_FDa. The a-th selection gate SGa may be connected between the a-th source follower SFa and a column line.

The b-th pixel PIXb may include a b-th photodiode PDb, a b-th transfer gate TGb, a b-th SFD circuit SFD_CKTb, a b-th LOFIC circuit Lo_CKTb, a b-th source follower SFb, and a b-th selection gate SGb. The c-th pixel PIXc may include a c-th photodiode PDc, a c-th transfer gate TGc, a c-th SFD circuit SFD_CKTc, a c-th LOFIC circuit Lo_CKTc, a c-th source follower SFc, and a c-th selection gate SGc. The d-th pixel PIXd may include a d-th photodiode PDd, a d-th transfer gate TGd, a d-th SFD circuit SFD_CKTd, a d-th LOFIC circuit Lo_CKTd, a d-th source follower SFd, and a d-th selection gate SGd. A structure of each of the b-th to d-th pixels PIXb to PIXd is similar to the structure of the a-th pixel PIXa, and thus, additional description will be omitted to avoid redundancy.

In some example embodiments, the plurality of pixels PIXa to PIXd may be connected to the same column line. Alternatively, the plurality of pixels PIXa to PIXd may be respectively connected to different column lines. Alternatively, some pixels PIXa and PIXc of the plurality of pixels PIXa to PIXd may be connected to a first column line, and the other pixels PIXb and PIXd of the plurality of pixels PIXa to PIXd may be connected to a second column line.

In some example embodiments, in the shared mode, the image sensor 100 may electrically connect FD nodes n_FDa to n_FDd of the plurality of pixels PIXa to PIXd to each other. For example, the FD nodes n_FDa to n_FDd may be electrically connected through SFD circuits SFD_CKTa to SFD_CKTd of the plurality of pixels PIXa to PIXd. That is, in the shared mode, the shared FD node n_SFD may be formed by electrically connecting the a-th to d-th FD nodes n_FDa to n_FDd during the sensing operation of the a-th pixel PIXa. In this case, the pixel capacitance of the a-th pixel PIXa may correspond to the shared FD node n_SFD (i.e., a sum of the a-th to d-th FD nodes n_FDa to n_FDd). As described above, in the shared mode, the image sensor 100 may control the pixel capacitance or the conversion gain of each pixel by electrically connecting FD nodes of a plurality of pixels. In some example embodiments, in the LOFIC mode, the image sensor 100 may electrically connect an FD node of each pixel and a capacitor of an LOFIC circuit (e.g., one of Lo_CKTa to Lo_CKTd) of each pixel by using the LOFIC circuit (e.g., one of Lo_CKTa to Lo_CKTd), for each pixel.

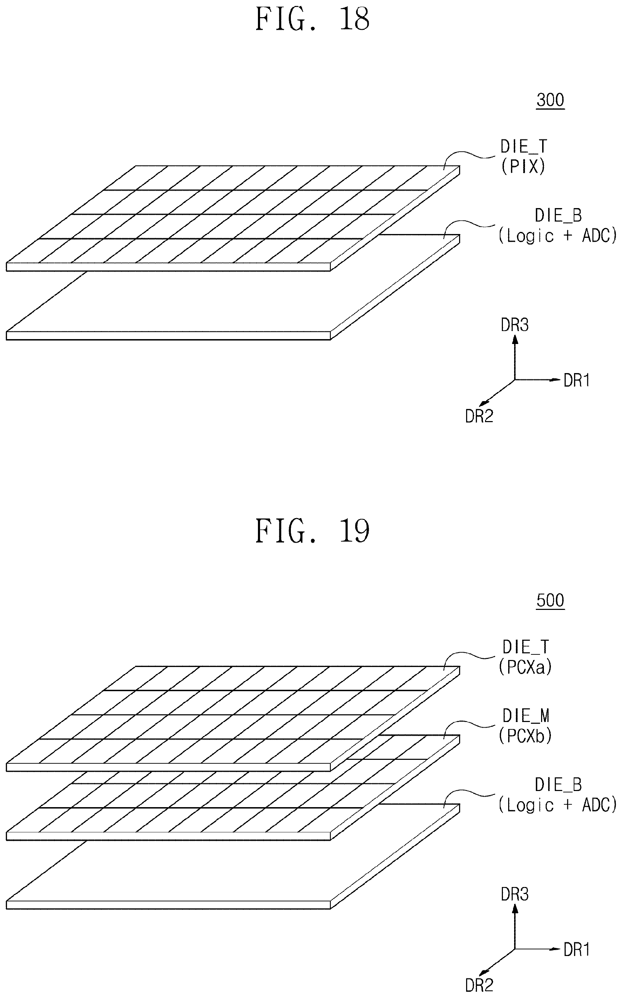

FIG. 18 is a diagram illustrating a method of forming a stacked structure of an image sensor of FIG. 2. Referring to FIGS. 2 and 18, an image sensor 300 may include a top semiconductor die DIE_T (for convenience of description, hereinafter, referred to as a "top die") and a bottom semiconductor die DIE_B (for convenience of description, hereinafter, referred to as a "bottom die"). The top die DIE_T may include the pixel array 110 including the plurality of pixels PIX. The bottom die DIE_B may include the remaining components (e.g., an ADC and a logic circuit) other than the pixel array 110.

In some example embodiments, each of the top die DIE_T and the bottom die DIE_B may indicate a semiconductor chip, a semiconductor wafer, or a semiconductor die, which is separately implemented or manufactured. The top die DIE_T and the bottom die DIE_B may be stacked based on various methods such as a chip-to-chip (C2C) bonding and a combination of a through hole and a metal pad; example embodiments are not limited thereto.

FIG. 19 is a diagram illustrating a stacked structure of an image sensor of FIG. 2. Referring to FIGS. 2 and 19, an image sensor 500 may include a top semiconductor die DIE_T (for convenience of description, hereinafter, referred to as a "top die"), a middle semiconductor die DIE_M (for convenience of description, hereinafter, referred to as a "middle die"), and a bottom semiconductor die DIE_B (for convenience of description, hereinafter, referred to as a "bottom die").

The top die DIE_T may include a portion PCXa of a pixel circuit of each of the plurality of pixels PIX, and the middle die DIE_M may include the remaining portion PCXb of the pixel circuit of each of the plurality of pixels PIX. For example, it is assumed that the pixel array 110 includes the first pixel PIX1 of FIG. 5. A plurality of gates (e.g., TG1, SF1, SG1, FDGS1, RG1, LoSG1, LoRG1, DSW1, and CAP1) of the first pixel PIX1 may constitute a pixel circuit of the first pixel PIX1. The portion PCXa of the pixel circuit of the first pixel PIX1 and the first photodiode PD1 may be formed in the top die DIE_T, and the remaining portion PCXb of the pixel circuit of the first pixel PIX1 may be formed in the middle die DIE_M. The bottom die DIE_B may include the remaining components (e.g., an ADC and a logic circuit) other than the pixel array 110.

The top die DIE_T, the middle die DIE_M, and the bottom die DIE_B may be stacked based on various methods such as C2C bonding and a combination of a through hole and a metal pad.

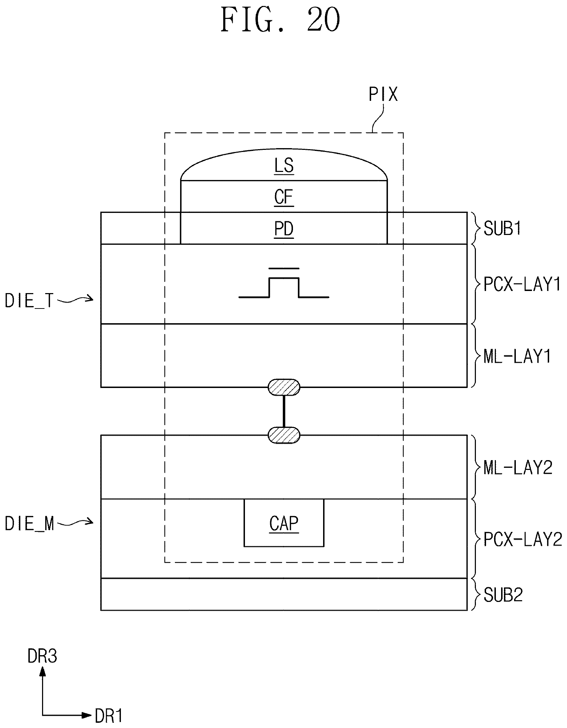

FIG. 20 is a diagram for describing a pixel included in an image sensor of a stacked structure of FIG. 19. The pixel PIX of the image sensor 500 may be formed in the top die DIE_T and the middle die DIE_M. For example, the top die DIE_T may include a first substrate SUB1. A photodiode PD may be formed in the first substrate SUB1. A color filter CF and a micro lens LS may be formed on the photodiode PD.

A first pixel circuit layer PCX-LAY1 may be formed under the first substrate SUB1. For example, the first pixel circuit layer PCX-LAY1 may include at least one of various gates or various transistors included in a pixel (e.g., the first pixel PIX1 of FIG. 5). A first metal layer ML-LAY1 may be formed under the first pixel circuit layer PCX-LAY1. The first metal layer ML-LAY1 may include a plurality of metal lines for electrically connecting various elements included in the top die DIE_T.

The middle die DIE_M may include a second substrate SUB2. A second pixel circuit layer PCX-LAY2 may be formed on the second substrate SUB2. The second pixel circuit layer PCX-LAY2 may include the others of the various gates or the various transistors included in the pixel (e.g., the first pixel PIX1 of FIG. 5). In some example embodiments, a capacitor CAP (e.g., the first capacitor CAP1 of FIG. 5) included in a pixel for the LOFIC mode may be included in the second pixel circuit layer PCX-LAY2 of the middle die DIE_M. For example, the capacitor CAP included in the pixel may have a relatively large size. Accordingly, by forming the capacitor of the relatively large size in a semiconductor die independent of a photodiode, the light reception area of the photodiode may be secured, and the complexity of circuit may be reduced. A second metal layer ML-LAY2 may be formed on the second pixel circuit layer PCX-LAY2. The second metal layer ML-LAY2 may include a plurality of metal lines for electrically connecting various elements included in the middle die DIE_M.

The first metal layer ML-LAY1 of the top die DIE_T may be electrically connected to the second metal layer ML-LAY2 of the middle die DIE_M through a connection structure C2C. In some example embodiments, one pixel may be implemented by electrically connecting the first pixel circuit layer PCX-LAY1 of the top die DIE_T and the second pixel circuit layer PCX-LAY2 of the middle die DIE_M through the connection structure C2C. In some example embodiments, the connection structure C2C may be a structure for C2C bonding, but example embodiments are not limited thereto.

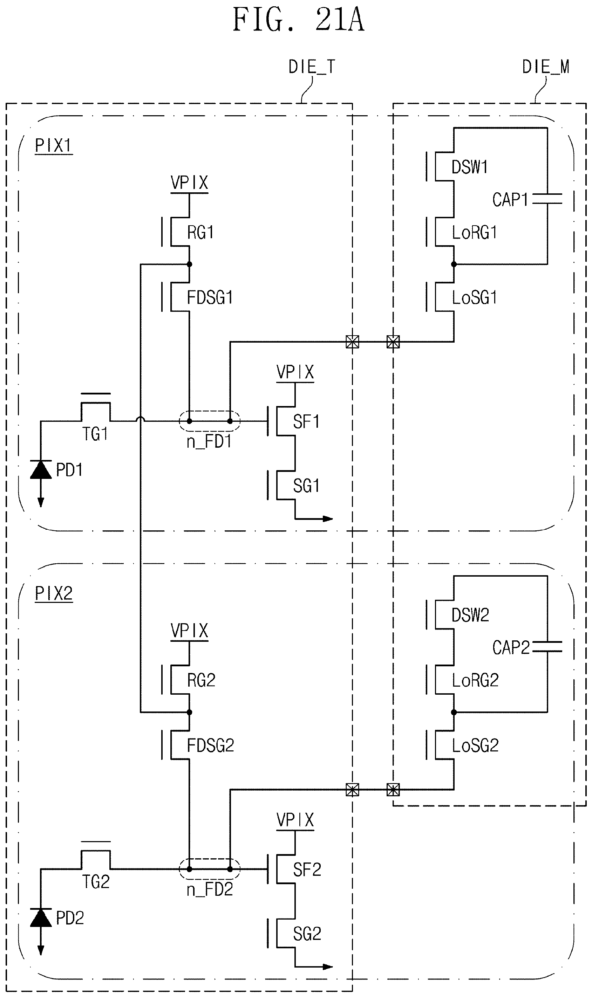

FIGS. 21A to 21E are diagrams illustrating some pixels included in an image sensor of a stacked structure of FIG. 19. Example embodiments in which each of the first and second pixels PIX1 and PIX2 is distributed and formed in the top die DIE_T and the middle die DIE_M will be described with reference to FIGS. 21A to 21E. For brevity of drawing and for convenience of description, various control signals configured to control the first and second pixels PIX1 and PIX2 are omitted in FIGS. 21A to 21E.

Referring to FIGS. 21A to 21E, the image sensor 500 may include the first pixel PIX1 and the second pixel PIX2. The first pixel PIX1 may include the first photodiode PD1, the first transfer gate TG1, the first FD selection gate FDSG1, the first reset gate RG1, the first source follower SF1, the first selection gate SG1, the first LOFIC selection gate LoSG1, the first LOFIC reset gate LoRG1, the first discharge switch DSW1, and the first capacitor CAP1. The second pixel PIX2 may include the second photodiode PD2, the second transfer gate TG2, the second FD selection gate FDSG2, the second reset gate RG2, the second source follower SF2, the second selection gate SG2, the second LOFIC selection gate LoSG2, the second LOFIC reset gate LoRG2, the second discharge switch DSW2, and the second capacitor CAP2. Structures, connection relationships, and operations of the first and second pixels PIX1 and PIX2 are described above, and thus, additional description will be omitted to avoid redundancy.

In some example embodiments, a portion of the pixel circuit of each of the first and second pixels PIX1 and PIX2 may be formed in the top die DIE_T, and the remaining portion thereof may be formed in the middle die DIE_M. In each of FIGS. 21A to 21E, the first and second pixels PIX1 and PIX2 are illustrated, but a configuration in which each of the first and second pixels PIX1 and PIX2 is distributed and formed in the top die DIE_T and the middle die DIE_M is similar to that of some example embodiments of each drawing, and thus, in each drawing, a configuration of only the first pixel PIX1 is described.

As illustrated in FIG. 21A, the first LOFIC selection gate LoSG1, the first LOFIC reset gate LoRG1, the first discharge switch DSW1, and the first capacitor CAP1 included in the first LOFIC circuit Lo_CKT1 of the first pixel PIX1 may be included in the middle die DIE_M. The remaining components PD1, TG1, FDSG1, RG1, SF1, and SG1 of the first pixel PIX1 may be included in the top die DIE_T. In the first pixel PIX1, the first FD node n_FD1 of the top die DIE_T and the first LOFIC selection gate LoSG1 of the middle die DIE_M may be electrically connected to each other through the C2C bonding-based connection structure.

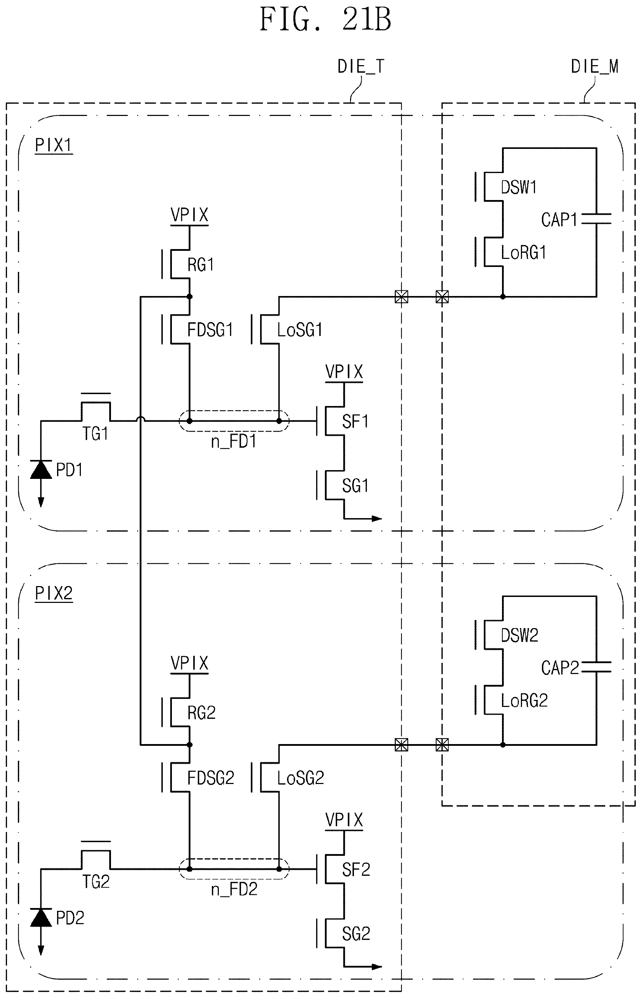

Next, as illustrated in FIG. 21B, the first LOFIC reset gate LoRG1, the first discharge switch DSW1, and the first capacitor CAP1 of the first pixel PIX1 may be included in the middle die DIE_M. The remaining components PD1, TG1, FDSG1, RG1, SF1, SG1, and LoSG1 of the first pixel PIX1 may be included in the top die DIE_T. In the first pixel PIX1, the first LOFIC selection gate LoSG1 of the top die DIE_T and the first capacitor CAP1 of the middle die DIE_M may be electrically connected through the C2C connection structure.

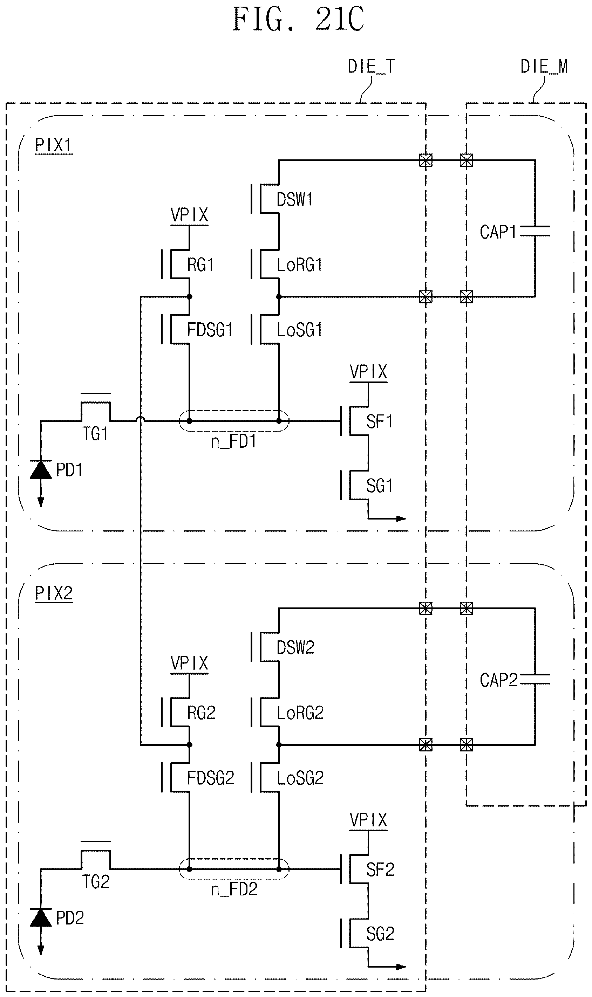

Then, as illustrated in FIG. 21C, the first capacitor CAP1 of the first pixel PIX1 may be included in the middle die DIE_M. The remaining components PD1, TG1, FDSG1, RG1, SF1, SG1, LoSG1, LoRG1, and DSW1 of the first pixel PIX1 may be included in the top die DIE_T. In the first pixel PIX1, the first node being between LoSG1 and LoRG1 and one end of the first discharge switch DSW1 in the top die DIE_T, and opposite ends of the first capacitor CAP1 may be electrically connected through the C2C connection structure.

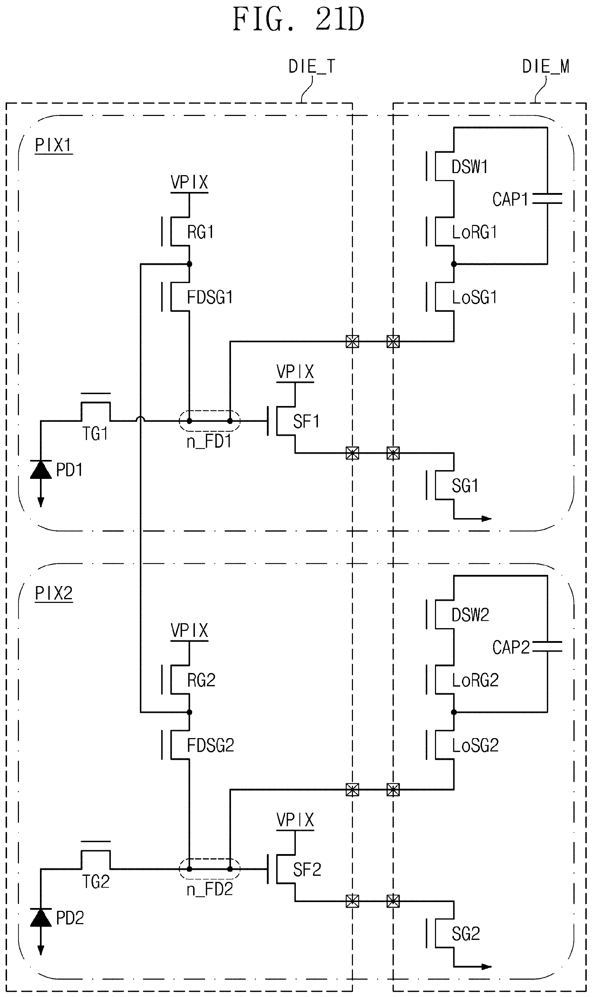

Referring to FIG. 21D, the first LOFIC selection gate LoSG1, the first LOFIC reset gate LoRG1, the first discharge switch DSW1, the first capacitor CAP1, and the first selection gate SG1 of the first pixel PIX1 may be included in the middle die DIE_M. The remaining components PD1, TG1, FDSG1, RG1, and SF1 of the first pixel PIX1 may be included in the top die DIE_T. In the first pixel PIX1, the first FD node n_FD1 and the first source follower SF1 of the top die DIE_T may be electrically connected to the first LOFIC selection gate LoSG1 and the first selection gate SG1 of the middle die DIE_M through the C2C connection structure, respectively.

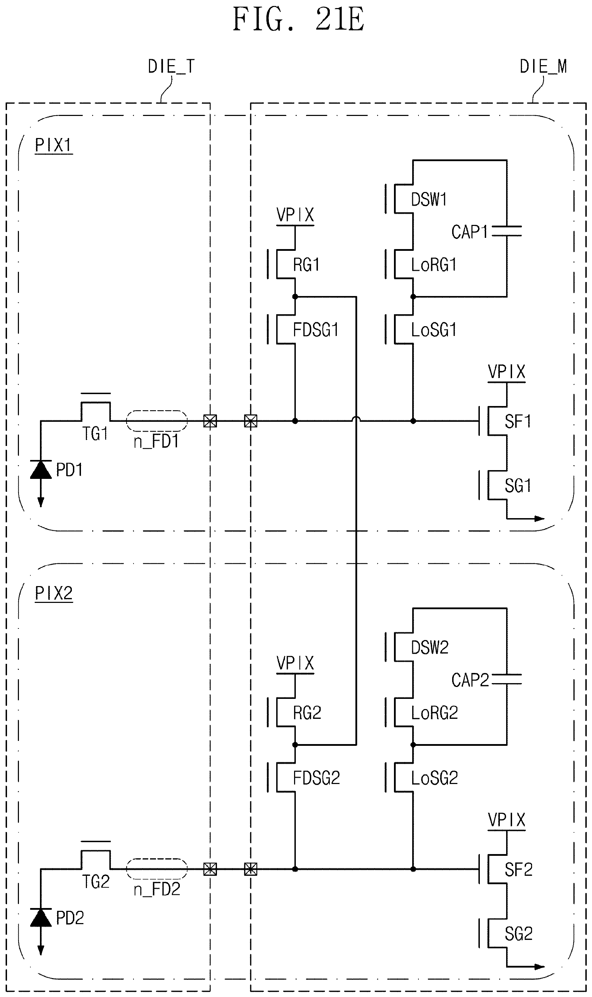

Referring to FIG. 21E, the first FD selection gate FDSG1, the first reset gate RG1, the first LOFIC selection gate LoSG1, the first LOFIC reset gate LoRG1, the first discharge switch DSW1, the first capacitor CAP1, the first source follower SF1, and the first selection gate SG1 may be formed in the middle die DIE_M. The remaining components PD1 and TG1 of the first pixel PIX1 may be formed in the top die DIE_T.

In the embodiments of FIGS. 21A to 21D, the first FD node n_FD1, the second FD node n_FD2, the first FD selection gate FDSG1, and the second FD selection gate FDSG2 may be included in the top die DIE_T. That is, in the shared mode, a metal line for connecting the first FD node n_FD1 of the first pixel PIX1 and the second FD node n_FD2 of the second pixel PIX2 may be formed in the top die DIE_T. Alternatively, the shared FD node of the first and second pixels PIX1 and PIX2 may be formed in the top die DIE_T.

In some example embodiments illustrated in FIG. 21E, the first FD node n_FD1 and the second FD node n_FD2 may be included in the top die DIE_T, and the first FD selection gate FDSG1 and the second FD selection gate FDSG2 may be formed in the middle die DIE_M. In this case is, in the shared mode, a metal line for connecting the first FD node n_FD1 of the first pixel PIX1 and the second FD node n_FD2 of the second pixel PIX2 may be formed in the middle die DIE_M. That is, the shared FD node of the first and second pixels PIX1 and PIX2 may be formed through the top die DIE_T and the middle die DIE_M.

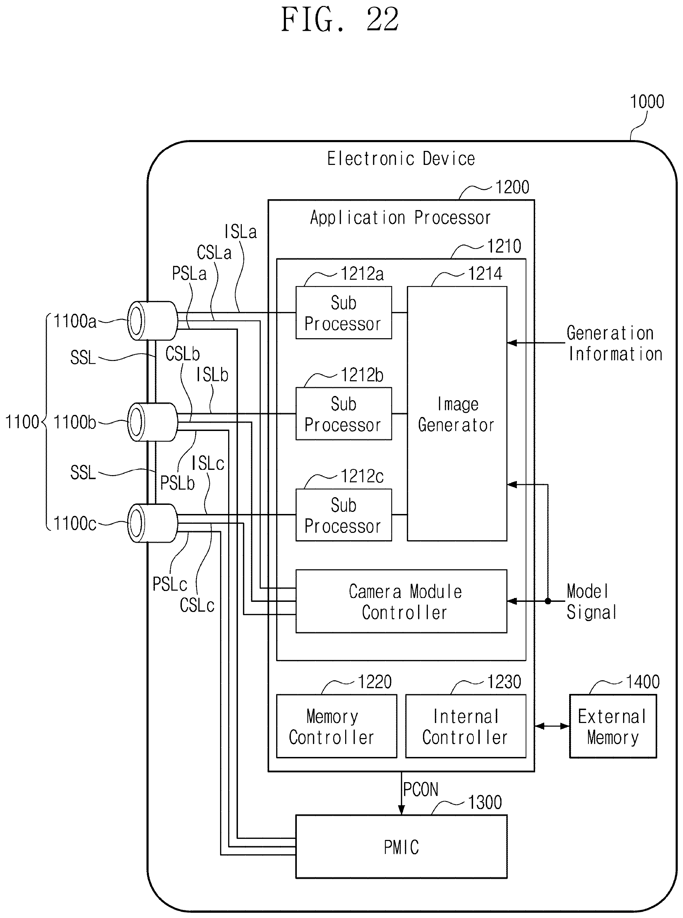

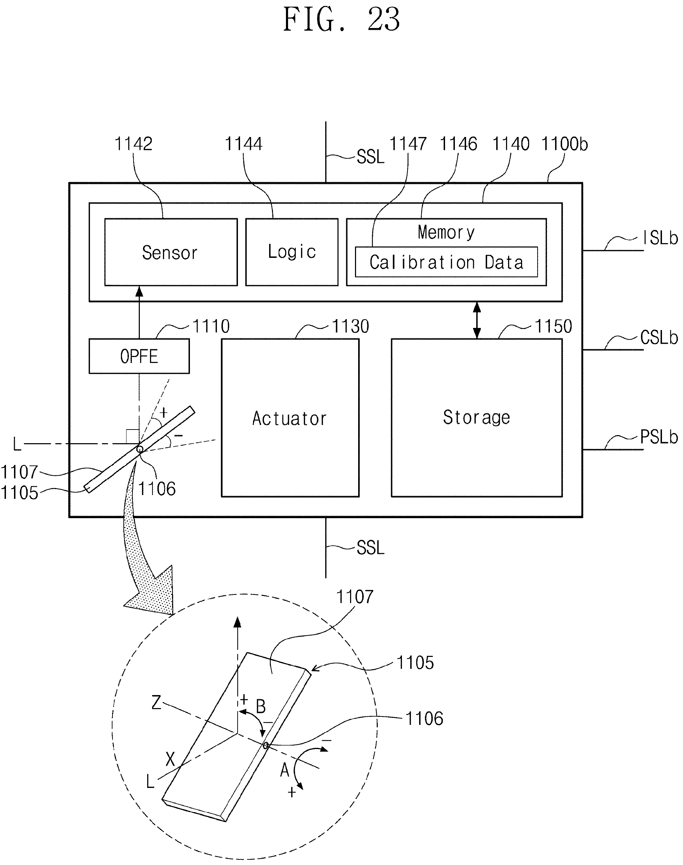

FIG. 22 is a block diagram of an electronic device including a multi-camera module. FIG. 23 is a block diagram illustrating a camera module of FIG. 22 in detail.

Referring to FIG. 22, an electronic device 1000 may include a camera module group 1100, an application processor 1200, a PMIC 1300, and an external memory 1400.

The camera module group 1100 may include a plurality of camera modules 1100a, 1100b, and 1100c. An electronic device including three camera modules 1100a, 1100b, and 1100c is illustrated in FIG. 22, but example embodiments are not limited thereto. In some embodiments, the camera module group 1100 may be modified to include only two camera modules. Also, in some embodiments, the camera module group 1100 may be modified to include "n" camera modules (n being a natural number of 4 or more).

Below, a detailed configuration of the camera module 1100b will be more fully described with reference to FIG. 23, but the following description may be equally applied to the remaining camera modules 1100a and 1100c.

Referring to FIG. 23, the camera module 1100b may include a prism 1105, an optical path folding element (OPFE) 1110, an actuator 1130, an image sensing device 1140, and storage 1150.

The prism 1105 may include a reflecting plane 1107 of a light reflecting material and may change a path of a light "L" incident from the outside.

In some embodiments, the prism 1105 may change a path of the light "L" incident in a first direction (X) to a second direction (Y) perpendicular to the first direction (X), Also, the prism 1105 may change the path of the light "L" incident in the first direction (X) to the second direction (Y) perpendicular to the first (X-axis) direction by rotating the reflecting plane 1107 of the light reflecting material in direction "A" about a central axis 1106 or rotating the central axis 1106 in direction "B". In this case, the OPFE 1110 may move in a third direction (Z) perpendicular to the first direction (X) and the second direction (Y).

In some embodiments, as illustrated in FIG. 23, a maximum rotation angle of the prism 1105 in direction "A" may be equal to or smaller than 15 degrees in a positive A direction and may be greater than 15 degrees in a negative A direction, but example embodiments are not limited thereto.

In some embodiments, the prism 1105 may move within approximately 20 degrees in a positive or negative B direction, between 10 degrees and 20 degrees, or between 15 degrees and 20 degrees; here, the prism 1105 may move at the same angle in the positive or negative B direction or may move at a similar angle within approximately 1 degree.

In some embodiments, the prism 1105 may move the reflecting plane 1107 of the light reflecting material in the third direction (e.g., Z direction) parallel to a direction in which the central axis 1106 extends.

The OPFE 1110 may include optical lenses composed of "m" groups (m being a natural number), for example. Here, "m" lens may move in the second direction (Y) to change an optical zoom ratio of the camera module 1100b. For example, when a default optical zoom ratio of the camera module 1100b is "Z", the optical zoom ratio of the camera module 1100b may be changed to an optical zoom ratio of 3Z, 5Z, or 5Z or more by moving "m" optical lens included in the OPFE 1110.

The actuator 1130 may move the OPFE 1110 or an optical lens (hereinafter referred to as an "optical lens") to a specific location. For example, the actuator 1130 may adjust a location of an optical lens such that an image sensor 1142 is placed at a focal length of the optical lens for accurate sensing.

The image sensing device 1140 may include the image sensor 1142, control logic 1144, and a memory 1146. The image sensor 1142 may sense an image of a sensing target by using the light "L" provided through an optical lens. The control logic 1144 may control overall operations of the camera module 1100b. For example, the control logic 1144 may control an operation of the camera module 1100b based on a control signal provided through a control signal line CSLb.

The memory 1146 may store information, which is necessary for an operation of the camera module 1100b, such as calibration data 1147. The calibration data 1147 may include information necessary for the camera module 1100b to generate image data by using the light "L" provided from the outside. The calibration data 1147 may include, for example, information about the degree of rotation described above, information about a focal length, information about an optical axis, etc. In the case where the camera module 1100b is implemented in the form of a multi-state camera in which a focal length varies depending on a location of an optical lens, the calibration data 1147 may include a focal length value for each location (or state) of the optical lens and information about auto focusing.

The storage 1150 may store image data sensed through the image sensor 1142. The storage 1150 may be disposed outside the image sensing device 1140 and may be implemented in a shape where the storage 1150 and a sensor chip constituting the image sensing device 1140 are stacked. In some embodiments, the storage 1150 may be implemented with an electrically erasable programmable read only memory (EEPROM), but example embodiments are not limited thereto.

Referring together to FIGS. 22 and 23, in some embodiments, each of the plurality of camera modules 1100a, 1100b, and 1100c may include the actuator 1130. As such, the same calibration data 1147 or different calibration data 1147 may be included in the plurality of camera modules 1100a, 1100b, and 1100c depending on operations of the actuators 1130 therein.

In some example embodiments, one camera module (e.g., 1100b) among the plurality of camera modules 1100a, 1100b, and 1100c may be a folded lens shape of camera module in which the prism 1105 and the OPFE 1110 described above are included, and the remaining camera modules (e.g., 1100a and 1100c) may be a vertical shape of camera module in which the prism 1105 and the OPFE 1110 described above are not included; however, example embodiments are not limited thereto.

In some example embodiments, one camera module (e.g., 1100c) among the plurality of camera modules 1100a, 1100b, and 1100c may be, for example, a vertical shape of depth camera extracting depth information by using an infrared ray (IR). In this case, the application processor 1200 may merge image data provided from the depth camera and image data provided from any other camera module (e.g., 1100a or 1100b) and may generate a three-dimensional (3D) depth image.

In some example embodiments, at least two camera modules (e.g., 1100a and 1100b) among the plurality of camera modules 1100a, 1100b, and 1100c may have different fields of view. In this case, the at least two camera modules (e.g., 1100a and 1100b) among the plurality of camera modules 1100a, 1100b, and 1100c may include different optical lens, but example embodiments are not limited thereto.

Also, in some embodiments, fields of view of the plurality of camera modules 1100a, 1100b, and 1100c may be different. In this case, the plurality of camera modules 1100a, 1100b, and 1100c may include different optical lenses, but the disclosure is not limited thereto.

In some example embodiments, the plurality of camera modules 1100a, 1100b, and 1100c may be disposed to be physically separated from each other. That is, the plurality of camera modules 1100a, 1100b, and 1100c may not use a sensing area of one image sensor 1142, but the plurality of camera modules 1100a, 1100b, and 1100c may include independent image sensors 1142 therein, respectively.

Returning to FIG. 22, the application processor 1200 may include an image processing device 1210, a memory controller 1220, and an internal memory 1230. The application processor 1200 may be implemented to be separated from the plurality of camera modules 1100a, 1100b, and 1100c. For example, the application processor 1200 and the plurality of camera modules 1100a, 1100b, and 1100c may be implemented with separate semiconductor chips.

The image processing device 1210 may include a plurality of sub image processors 1212a, 1212b, and 1212c, an image generator 1214, and a camera module controller 1216.

The image processing device 1210 may include the plurality of sub image processors 1212a, 1212b, and 1212c, the number of which corresponds to the number of the plurality of camera modules 1100a, 1100b, and 1100c.

Image data respectively generated from the camera modules 1100a, 1100b, and 1100c may be respectively provided to the corresponding sub image processors 1212a, 1212b, and 1212c through separated image signal lines ISLa, ISLb, and ISLc. For example, the image data generated from the camera module 1100a may be provided to the sub image processor 1212a through the image signal line ISLa, the image data generated from the camera module 1100b may be provided to the sub image processor 1212b through the image signal line ISLb, and the image data generated from the camera module 1100c may be provided to the sub image processor 1212c through the image signal line ISLc. This image data transmission may be performed, for example, by using a camera serial interface (CSI) based on the MIPI (Mobile Industry Processor Interface), but example embodiments are not limited thereto.

Meanwhile, in some example embodiments, one sub image processor may be disposed to correspond to a plurality of camera modules. For example, the sub image processor 1212a and the sub image processor 1212c may be integrally implemented, not separated from each other; in this case, one of the pieces of image data respectively provided from the camera module 1100a and the camera module 1100c may be selected through a selection element (e.g., a multiplexer), and the selected image data may be provided to the integrated sub image processor.

The image data respectively provided to the sub image processors 1212a, 1212b, and 1212c may be provided to the image generator 1214. The image generator 1214 may generate an output image by using the image data respectively provided from the sub image processors 1212a, 1212b, and 1212c, depending on image generating information Generating Information or a mode signal.

In detail, the image generator 1214 may generate the output image by merging at least a portion of the image data respectively generated from the camera modules 1100a, 1100b, and 1100c having different fields of view, depending on the image generating information Generating Information or the mode signal. Also, the image generator 1214 may generate the output image by selecting one of the image data respectively generated from the camera modules 1100a, 1100b, and 1100c having different fields of view, depending on the image generating information Generating Information or the mode signal.

In some example embodiments, the image generating information Generating Information may include a zoom signal or a zoom factor. Also, in some embodiments, the mode signal may be, for example, a signal based on a mode selected from a user.

In the case where the image generating information Generating Information is the zoom signal (or zoom factor) and the camera modules 1100a, 1100b, and 1100c have different visual fields of view, the image generator 1214 may perform different operations depending on a kind of the zoom signal. For example, in the case where the zoom signal is a first signal, the image generator 1214 may merge the image data output from the camera module 1100a and the image data output from the camera module 1100c and may generate the output image by using the merged image signal and the image data output from the camera module 1100b that is not used in the merging operation. In the case where the zoom signal is a second signal different from the first signal, without the image data merging operation, the image generator 1214 may select one of the image data respectively output from the camera modules 1100a, 1100b, and 1100c and may output the selected image data as the output image. However, example embodiments are not limited thereto, and a way to process image data may be modified without limitation if necessary.

In some example embodiments, the image generator 1214 may generate merged image data having an increased dynamic range by receiving a plurality of image data of different exposure times from at least one of the plurality of sub image processors 1212a, 1212b, and 1212c and performing high dynamic range (HDR) processing on the plurality of image data.

The camera module controller 1216 may provide control signals to the camera modules 1100a, 1100b, and 1100c, respectively. The control signals generated from the camera module controller 1216 may be respectively provided to the corresponding camera modules 1100a, 1100b, and 1100c through control signal lines CSLa, CSLb, and CSLc separated from each other.

One of the plurality of camera modules 1100a, 1100b, and 1100c may be designated as a master camera (e.g., 1100b) depending on the image generating information Generating Information including a zoom signal or the mode signal, and the remaining camera modules (e.g., 1100a and 1100c) may be designated as a slave camera. The above designation information may be included in the control signals, and the control signals including the designation information may be respectively provided to the corresponding camera modules 1100a, 1100b, and 1100c through the control signal lines CSLa, CSLb, and CSLc separated from each other.

Camera modules operating as a master and a slave may be changed depending on the zoom factor or an operating mode signal. For example, in the case where the field of view of the camera module 1100a is wider than the field of view of the camera module 1100b and the zoom factor indicates a low zoom ratio, the camera module 1100b may operate as a master, and the camera module 1100a may operate as a slave. In contrast, in the case where the zoom factor indicates a high zoom ratio, the camera module 1100a may operate as a master, and the camera module 1100b may operate as a slave.

In some example embodiments, the control signal provided from the camera module controller 1216 to each of the camera modules 1100a, 1100b, and 1100c may include a sync enable signal. For example, in the case where the camera module 1100b is used as a master camera and the camera modules 1100a and 1100c are used as a slave camera, the camera module controller 1216 may transmit the sync enable signal to the camera module 1100b. The camera module 1100b that is provided with sync enable signal may generate a sync signal based on the provided sync enable signal and may provide the generated sync signal to the camera modules 1100a and 1100c through a sync signal line SSL. The camera module 1100b and the camera modules 1100a and 1100c may be synchronized with the sync signal to transmit image data to the application processor 1200.

In some example embodiments, the control signal provided from the camera module controller 1216 to each of the camera modules 1100a, 1100b, and 1100c may include mode information according to the mode signal. Based on the mode information, the plurality of camera modules 1100a, 1100b, and 1100c may operate in a first operating mode and a second operating mode with regard to a sensing speed.

In the first operating mode, the plurality of camera modules 1100a, 1100b, and 1100c may generate image signals at a first speed (e.g., may generate image signals of a first frame rate), may encode the image signals at a second speed (e.g., may encode the image signal of a second frame rate higher than the first frame rate), and transmit the encoded image signals to the application processor 1200. In this case, the second speed may be 30 times or less the first speed.

The application processor 1200 may store the received image signals, that is, the encoded image signals in the memory 1230 provided therein or the external memory 1400 placed outside the application processor 1200. Afterwards, the application processor 1200 may read and decode the encoded image signals from the memory 1230 or the external memory 1400 and may display image data generated based on the decoded image signals. For example, the corresponding one among sub image processors 1212a, 1212b, and 1212c of the image processing device 1210 may perform decoding and may also perform image processing on the decoded image signal.

In the second operating mode, the plurality of camera modules 1100a, 1100b, and 1100c may generate image signals at a third speed (e.g., may generate image signals of a third frame rate lower than the first frame rate) and transmit the image signals to the application processor 1200. The image signals provided to the application processor 1200 may be signals that are not encoded. The application processor 1200 may perform image processing on the received image signals or may store the image signals in the memory 1230 or the storage 1400.

The PMIC 1300 may supply powers, for example, power supply voltages to the plurality of camera modules 1100a, 1100b, and 1100c, respectively. For example, under control of the application processor 1200, the PMIC 1300 may supply a first power to the camera module 1100a through a power signal line PSLa, may supply a second power to the camera module 1100b through a power signal line PSLb, and may supply a third power to the camera module 1100c through a power signal line PSLc.

In response to a power control signal PCON from the application processor 1200, the PMIC 1300 may generate a power corresponding to each of the plurality of camera modules 1100a, 1100b, and 1100c and may adjust a level of the power. The power control signal PCON may include a power adjustment signal for each operating mode of the plurality of camera modules 1100a, 1100b, and 1100c. For example, the operating mode may include a low-power mode. In this case, the power control signal PCON may include information about a camera module operating in the low-power mode and a set power level. Levels of the powers respectively provided to the plurality of camera modules 1100a, 1100b, and 1100c may be identical to each other or may be different from each other. Also, a level of a power may be dynamically changed.

In some example embodiments, the plurality of pixels included in each of the camera modules 1100a, 1100b, and 1100c may be the pixels described with reference to FIGS. 1 to 21E. For example, each of the plurality of pixels included in each of the camera modules 1100a, 1100b, and 1100c may share the FD node of an adjacent pixel in the shared mode and may perform the LOFIC-based sensing operation through the capacitor included in each pixel in the LOFIC mode.

According to some example embodiments, an image sensor with improved performance and/or improved reliability, and/or an operation method thereof, are provided.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

While inventive concepts have been described with reference to some example embodiments thereof, it will be apparent to those of ordinary skill in the art that various changes and modifications may be made thereto without departing from the scope of inventive concepts as set forth in the following claims. Additionally, example embodiments are not necessarily mutually exclusive with one another. For example, some example embodiments may include one or more features described with reference to one or more figures, and may also include one or more other features described with reference to one or more other figures.

Embodiments are set out in the following clauses:
Clause 1. An operation method of an image sensor which includes a first pixel and a second pixel,
   wherein the first pixel includes a first photodiode, a first floating diffusion (FD) node, a first shared floating diffusion (SFD) circuit connected to the first FD node, and a first lateral overflow integration capacitor (LOFIC) circuit connected to the first FD node, and
   wherein the second pixel includes a second photodiode, a second FD node, a second SFD circuit connected to the second FD node, and a second LOFIC circuit connected to the second FD node,
   the method comprising:
      in a shared mode, electrically connecting the first FD node and the second FD node by disabling the first LOFIC circuit and enabling the first SFD circuit and performing a sensing operation on the first pixel based on the first and second FD nodes; and
      in an LOFIC mode, electrically connecting the first FD node and a first capacitor included in the first LOFIC circuit by disabling the first SFD circuit and enabling the first LOFIC circuit and performing a sensing operation on the first pixel based on the first FD node and the first capacitor, wherein
      during the sensing operation on the first pixel in the shared mode, the first capacitor is electrically separated from the first FD node, and
      during the sensing operation on the first pixel in the LOFIC mode, the second FD node is electrically separated from the first FD node.
Clause 2. The method of clause 1, wherein the sensing operation on the first pixel in the shared mode includes:
   during a first period, electrically connecting the first FD node and the second FD node and resetting the first and second FD nodes;
   during a second period following the first period, sampling a low conversion gain reset value corresponding to a voltage of the first and second FD nodes;
   during a third period following the second period, electrically separating the first FD node from the second FD node and sampling a high conversion gain reset value corresponding to a voltage of the first FD node;
   during a fourth period following the third period, transferring photodiodes of the first photodiode of the first pixel to the first FD node;
   during a fifth period following the fourth period, sampling a high conversion gain signal value corresponding to a voltage of the first FD node;
   during a sixth period following the fifth period, electrically connecting the first FD node and the second FD node and sampling a low conversion gain signal value corresponding to a voltage of the first and second FD nodes.
Clause 3. The method of clause 1 or clause 2, wherein the sensing operation on the first pixel in the LOFIC mode includes:
   during a first period, sampling a high conversion gain reset value corresponding to a voltage of the first FD node;
   during a second period following the first period, transferring photoelectrons of the first photodiode to the first FD node;
   during a third period following the second period, sampling a high conversion gain signal value corresponding to a voltage of the first FD node;
   during a fourth period following the third period, electrically connecting the first FD node and the first capacitor and sampling a LOFIC signal value corresponding to a voltage of the first FD node and the first capacitor;
   during a fifth period following the fourth period, resetting the first FD node and the first capacitor; and
   during a sixth period following the fifth period, sampling an LOFIC reset value corresponding to a voltage of the first FD node and the first capacitor.
Clause 4. The method of any of clauses 1 to 3, wherein the sensing operation on the first pixel in the LOFIC mode includes:
   during a first period, electrically connecting the first FD node and the first capacitor and sampling an LOFIC signal value corresponding to a voltage of the first FD node and the first capacitor;
   during a second period following the first period, resetting the first FD node and the first capacitor;
   during a third period following the second period, sampling an LOFIC reset value corresponding to a voltage of the first FD node and the first capacitor;
   during a fourth period following the third period, electrically separating the first FD node from the first capacitor and sampling a high conversion gain reset value corresponding to a voltage of the first FD node;
   during a fifth period following the fourth period, transferring photoelectrons of the first photodiode to the first FD node; and
   during a sixth period following the fifth period, sampling a high conversion gain signal value corresponding to a voltage of the first FD node.
Clause 5. An image sensor comprising
   a first photodiode;
   a first transfer gate connected between the first photodiode and a first floating diffusion (FD) node;
   a first shared floating diffusion (SFD) circuit connected to the first FD node;
   a first lateral overflow integration capacitor (LOFIC) circuit connected to the first FD node and including a first capacitor;
   a first source follower including a first gate terminal connected to the first FD node; and
   a first selection gate connected between the first source follower and a first column line,
   wherein the image sensor is configured to operate in a shared mode and in an LOFIC mode such that, in the shared mode, the first SFD circuit is configured to electrically connect the first FD node to a second FD node different from the first FD node, and
   in the LOFIC mode, the first LOFIC circuit is configured to electrically connect the first FD node to the first capacitor.
Clause 6. The image sensor of clause 5, wherein
   the first SFD circuit includes,
   a first FD selection gate connected between a first node electrically connected to the second FD node and the first FD node, and
   a first reset gate connected between the first node and a pixel voltage, and the first LOFIC circuit includes,
   a first LOFIC selection gate connected between the first FD node and a first LOFIC node, and
   a first capacitor connected between the first LOFIC node and a first reset voltage.
Clause 7. The image sensor of clause 5 or clause 6, further comprising:
   a second photodiode;
   a second transfer gate connected between the second photodiode and the second FD node;
   a second SFD circuit connected to the second FD node;
   a second LOFIC circuit connected to the second FD node and including a second capacitor;
   a second source follower including a second gate terminal connected to the second FD node; and
   a second selection gate connected between the second source follower and the first column line.

## Claims

1. An image sensor (100) comprising:
a first pixel (PIX1) including a first photodiode (PD1), the first pixel (PIX1) configured to output a first output voltage corresponding to light incident onto the first photodiode (PD1); and
a second pixel (PIX2) including a second photodiode (PD2), the second pixel (PIX2) configured to output a second output voltage corresponding to light incident onto the second photodiode (PD2),
wherein the first pixel (PIX1) further includes,
a first transfer gate (TG1) connected between the first photodiode (PD1) and a first floating diffusion (FD) node (n_FD1),
a first FD selection gate (FDSG1) connected between a first node (n1) and the first FD node (n_FD1),
a first lateral overflow integration capacitor (LOFIC) selection gate (LoSG1) connected between the first FD node (n_FD1) and a first LOFIC node (n_Lo1), and
a first capacitor (CAP1) connected between the first LOFIC node (n_Lo1) and a first reset voltage (VRST1), and
wherein the second pixel (PIX2) further includes,
a second transfer gate (TG2) connected between the second photodiode (PD2) and a second FD node (n_FD2),
a second FD selection gate (FDSG2) connected between a second node (n2) electrically connected to the first node (n1) and the second FD node (n_FD2),
a second LOFIC selection gate (LoSG2) connected between the second FD node (n_FD2) and a second LOFIC node (n_Lo2), and
a second capacitor (CAP2) connected between the second LOFIC node (n_Lo2) and the first reset voltage (VRST1).

2. The image sensor (100) of claim 1, wherein
the first capacitor (CAP1) includes at least one of a metal-insulator-metal (MIM) capacitor, a metal-oxide-metal (MOM) capacitor, a metal-oxide-semiconductor capacitor (MOSCAP), a polysilicon capacitor, and a DRAM capacitor, and
the second capacitor includes at least one of a MIM capacitor, a MOM capacitor, a MOSCAP, a polysilicon capacitor, and a DRAM capacitor.

3. The image sensor (100) of claim 1 or claim 2, wherein, in response to the image sensor operating in an LOFIC mode in which the first and second FD selection gates (FDSG1, FDSG2) are configured to be turned off,
the first and second LOFIC selection gates (LoSG1, LoSG2) are configured to be turned on,
the first FD node (n_FD1) and the first capacitor (CAP1) are configured to be electrically connected, and
the second FD node (n_FD2) and the second capacitor (CAP2) are configured to be electrically connected.

4. The image sensor (100) of claim 3, wherein
the first pixel (PIX1) further includes,
a first LOFIC reset gate (LoRG1) connected between the first LOFIC node (n_Lo1) and a second reset voltage (VRST2), and
a first discharge switch (DSW1) connected between the first reset voltage (VRST1) and the second reset voltage (VRST2), and
wherein the second pixel (PIX2) further includes,
a second LOFIC reset gate (LoRG2) connected between the second LOFIC node (n_FD2) and the second reset voltage (VRST2), and
a second discharge switch (DSW2) connected between the first reset voltage (VRST1) and the second reset voltage (VRST2).

5. The image sensor (100) of claim 4, wherein, in response to the image sensor (100) operating in the LOFIC mode,
the first FD node (n_FD1) and the first capacitor (CAP1) are configured to be reset through the first LOFIC reset gate (LoRG1) and the first discharge switch (DSW1), and
the second FD node (n_FD2) and the second capacitor (CAP2) are configured to be reset through the second LOFIC reset gate (LoRG2) and the second discharge switch (DSW2).

6. The image sensor (100) of claim 1 or claim 2, wherein
the first pixel (PIX1) further includes,
a first LOFIC reset gate (LoRG1a) connected between the first LOFIC node (n_Lo1a) and a third LOFIC node (n_Lolb),
a third LOFIC reset gate (LoRG1b) connected between the third LOFIC node (n_Lolb) and a second reset voltage (VRST2),
a first discharge switch (DWS1) connected between the first reset voltage (VRST1) and the second reset voltage (VRST2), and
a third capacitor (CAP1b) connected between the third LOFIC node (n_Lolb) and the first reset voltage (VRST1), and
wherein the second pixel (PIX2) further includes:
a second LOFIC reset gate (LoRG2a) connected between the second LOFIC node (n_Lo2a) and a fourth LOFIC node (n_Lo2b),
a fourth LOFIC reset gate (LoRG2b) connected between the fourth LOFIC node (n_LoRG2b) and the second reset voltage (VRST2),
a second discharge switch (DSW2) connected between the first reset voltage (VRST1) and the second reset voltage (VRST2), and
a fourth capacitor (CAP2b) connected between the fourth LOFIC node (n_Lo2b) and the first reset voltage (VRST1).

7. The image sensor (100) of any preceding claim, wherein, in response to the image sensor (100) operating in a shared mode in which the first and second LOFIC selection gates (LoSG1, LoSG2) are configured to be turned off and the first and second FD selection gates (FDSG1, FDSG2) are configured to be turned on, the first and second FD nodes (n_FD1, n_FD2) are configured to be electrically connected.

8. The image sensor (100) of claim 7, wherein
the first pixel (PIX1) further includes a first reset gate (RG1) connected between the first node (n1) and a pixel voltage (VPIX), and
the second pixel (PIX2) further includes a second reset gate (RG2) connected between the second node (n2) and the pixel voltage (VPIX).

9. The image sensor (100) of claim 8, wherein, in response to the image sensor (100) operating in the shared mode, the first and second FD nodes (n_FD1, n_FD2) are configured to be reset through the first reset gate (RG1) and the second reset gate (RG2).

10. The image sensor (100) of any of claims 1-7, wherein
the first pixel (PIX1) further includes,
a first reset gate (RG1) connected between the first node (n1) and a third FD node (n_FDa), and
a third reset gate (LRG1) connected between the third FD node (n_FDa) and a pixel voltage (VPIX), and
the second pixel (PIX2) further includes,
a second reset gate (MRG2) connected between the second node (n2) and a fourth FD node (n_FDb), and
a fourth reset gate (LRG2) connected between the fourth FD node (n_FDb) and the pixel voltage (VPIX).

11. The image sensor of any preceding claim, wherein
the first pixel (PIX1) further includes,
a third photodiode (LPD1), and
a third transfer gate (LTG1) connected between the third photodiode (LPD1) and the first FD node (n_FD1), and
the second pixel (PIX2) further includes.
a fourth photodiode (LPD2); and
a fourth transfer gate (LTG2) connected between the fourth photodiode (LPD2) and the second FD node (n_FD2).

12. The image sensor (100) of any preceding claim, further comprising:
a third pixel including a third photodiode, the third pixel configured to output a third output voltage corresponding to the light incident onto the third photodiode,
wherein the third pixel further includes,
a third transfer gate connected between the third photodiode and a third FD node;
a third FD selection gate connected between a third node electrically connected to the first and second nodes (n1, n2) and the third FD node,
a third LOFIC selection gate connected between the third FD node and a third LOFIC node, and
a third capacitor connected between the third LOFIC node and a third reset voltage.

13. The image sensor (100) of any preceding claim, wherein
the first pixel (PIX1) further includes a first source follower (SF1) and a first selection gate (SG1) connected in series between a pixel voltage (VPIX) and a first column line (CL1),
a gate terminal of the first source follower (SF1) is connected to the first FD node (n_FD1),
the second pixel (PIX2) further includes a second source follower (SF2) and a second selection gate (SG2) connected in series between the pixel voltage (VPIX) and the first column line (CL1),
a gate terminal of the second source follower (SF2) is connected to the second FD node (n_FD2), and
the first column line (CL1) is configured to output each of the first and second output voltages.

14. The image sensor (100) of any of claims 1-12, wherein
the first pixel (PIX1) further includes a first source follower (SF1) and a first selection gate (SG1) connected in series between a pixel voltage (VPIX) and a first column line (CL1),
a gate terminal of the first source follower (SF1) is connected to the first FD node (n_FD1),
the second pixel (PIX2) further includes a second source follower (SF2) and a second selection gate (SG2) connected in series between the pixel voltage (VPIX) and a second column line,
a gate terminal of the second source follower (SF2) is connected to the second FD node (n_FD2),
the first column line (CL1) is configured to output the first output voltage, and
the second column line is configured to output the second output voltage.

15. The image sensor (100) of any preceding claim, further comprising:
a first semiconductor die (DIE_T); and
a second semiconductor die (DIE_M) stacked on the first semiconductor die (DIE_T), and configured to be electrically connected to the first semiconductor die (DIE_T) through a connection structure,
wherein the first photodiode (PD1) and the second photodiode (PD2) are in the first semiconductor die (DIE_T), and
wherein the first capacitor (CAP1) and the second capacitor (CAP2) are in the second semiconductor die (DIE_M).
